# EUROPEAN PATENT APPLICATION

(11) **EP 1 757 983 A1**
(43) Date of publication of application: **28.02.2007**
(21) Application number: 06001858.7
(22) Date of filing: 30.01.2006
(51) Int. Cl.: G03F 7/039, G03F 7/038, G03F 7/40

(54) **Resist composition, method for forming resist pattern, semiconductor device and method for manufacturing thereof**

(30) Priority: 23.08.2005 JP 2005241665
(71) Applicant: Fujitsu Ltd., Kawasaki-shi, Kanagawa 211-8588 (JP)
(72) Inventor: Nozaki, Koji, Kawasaki-shi Kanagawa 211-8588 (JP); Namiki, Takahisa, Kawasaki-shi Kanagawa 211-8588 (JP); Kozawa, Miwa, Kawasaki-shi Kanagawa 211-8588 (JP)
(74) Representative: Körfer, Thomas

(57) **Abstract**

A composition contains a resist material and an ammonium sulfate. A resist pattern formed from the composition can be uniformly thickened by a resist thickening material, thereby allowing formation of fine patterns beyond the resolution limit of the exposure devices.

## Description

### CROSS-REFERENCE TO RELATED APPLICATIONS

This application is based upon and claims the benefit of priority from the prior Japanese Patent Application No. 2005-241665, filed on August 23, 2005, the entire contents of which are incorporated herein by reference.

### BACKGROUND OF THE INVENTION

### Field of the Invention

The present invention relates to a resist composition suitable for a resist pattern utilized in the process of manufacturing a semiconductor device, a method for forming a resist pattern in which the resist pattern is thickened and hence a fine space pattern is formed by the thickened resist pattern, exceeding exposure limits of a light source of the available exposure device, and a semiconductor and a method for manufacturing a semiconductor using the resist composition.

### Description of the Related Art

Semiconductor integrated circuits are becoming more highly integrated, and LSIs and VLSIs are being put into practical use. Accompanying this trend, the size of the wiring patterns extend to regions of 0.2 µm or less, and the smallest patterns extend to regions of 0.1 µm or less. A lithographic technique is extremely important in forming fine wiring patterns. In the lithographic technique, a substrate is coated with a resist film, is selectively exposed, and thereafter, is developed to thereby form a resist pattern. Dry etching is carried out by using the resist pattern as a mask, and thereafter, by removing the resist pattern, the desired pattern is obtained. In forming a fine wiring pattern utilizing the lithographic technique, it is necessary to make the light source of the exposure device to be a short wavelength, as well as to develop resist materials which have high resolution and are suitable to the characteristics of the light source.

However, in order to make a light source of an exposure device to be a short wavelength, it is necessary to improve the exposure device, which results in very high costs. Further, the development of new resist materials suitable for an exposure with light of short wavelength is not easy.

In view of the above, there has been proposed a technique that a formed resist pattern is thickened by using a resist pattern thickening material (hereinafter, the resist pattern thickening material being sometimes referred to as "resist swelling material") to make the space pattern fine. For instance, Japanese Patent Application Laid-Open (JP-A) No. 10-73927 has proposed a technique called RELACS (Resolution Enhancement Lithography Assisted by Chemical Shrinkage). According to the disclosure, the resist patterns are formed by exposing a positive or negative resist material to an exposure light such as a KrF (krypton fluoride) excimer laser light having a wavelength of 248 nm, that is a deep ultraviolet light. Thereafter, a water-soluble resin composition is applied to form a coated film to cover the resist pattern. The coated film and the resist pattern interacts at the interface thereof by the action of the residual acid included in the resist pattern, so as to thicken the resist pattern (hereinafter, the thickening of the resist pattern being sometimes referred to as "swelling"). In this way, the space between the resist patterns is shortened, and a fine space pattern is formed. Thereafter, a desired pattern (e.g. wiring pattern) having the same dimension as the space pattern is formed.

In the RELACS technique, however, there are the following objectives. The KrF resist for use is formed of an aromatic resin composition including a novolak resin, naphthoquinonediazide resin or the like. An aromatic ring contained in the aromatic resin composition allows KrF excimer laser light (wavelength: 248 nm) to pass through, but absorbs ArF excimer laser light (wavelength: 193 nm) having a shorter wavelength than the KrF excimer laser light, and does not allow the ArF excimer laser light to pass through. Therefore, when the KrF resist is used, ArF excimer laser light cannot be used as the exposure light, which makes it impossible to form a finer wiring pattern, etc. Moreover, the resist swelling material is effective in thickening or swelling the KrF resist, but ineffective in thickening or swelling the ArF resist. In addition, the resist swelling material has low etch resistance itself. Thus, when ArF resist pattern having low etch-resistance is swelled, the same dimension as the swelled pattern cannot be patterned on the substrate to be processed. Furthermore, even if KrF resist having relatively satisfactory etch resistance is swelled, in such cases where etching condition is severe, where the KrF resist pattern is fine, where the resist film is thin, or the like, there is a problem that etching cannot be precisely carried out and a pattern having the same dimension as the swelled pattern cannot be obtained.

From the standpoint of forming a fine wiring pattern, it is desirable to use a light of a shorter wavelength than KrF excimer laser light, e.g., ArF excimer laser light, as the light source of the exposure device. When an x-ray or electron beam having a shorter wavelength than the ArF excimer laser light is applied as an exposure light to form the pattern, however, it results in high cost and low productivity. Thus, the utilization of ArF excimer laser light is desired.

As mentioned above, in the RELACS technique, the aforementioned resist swelling material does not efficiently work on ArF resist pattern. The present inventors have proposed a resist pattern thickening material capable of forming a fine pattern by improving affinity with the ArF resist pattern caused by a surfactant (refer to JP-A No. 2003-131400). However, the composition of the resist pattern thickening material sometimes causes dependency to the pattern size before thickening. That is, when the pattern size before thickening increases, the reduced amount of the pattern size after thickening may increase in proportion to the increase. Thus, there was a problem that when the resist pattern thickening material was used for a line-space pattern, on a wiring layer of LOGIC LSI where various sizes of resist patterns are used, the burden on designing an exposure mask could not fully be alleviated.

That is, when a resist pattern formed with a conventional resist composition is thickened by using a resist pattern thickening material, the resist pattern along the narrow side directions, or a region where elements of the resist pattern are sparsely located to each other, i.e. a region where space between the elements of the resist pattern is wide, has a small thickened amount due to a small amount of exposure dose near the pattern, whereas the resist pattern along the wide side directions, or a region where the elements of the resist pattern are closely located to each other, i.e. a region where a space between the elements of the resist pattern is narrow, has a large thickening amount due to a large amount of exposure dose. Accordingly, a thickening amount of the resist pattern largely varies depending on the direction and/or spacing variations of the resist pattern.

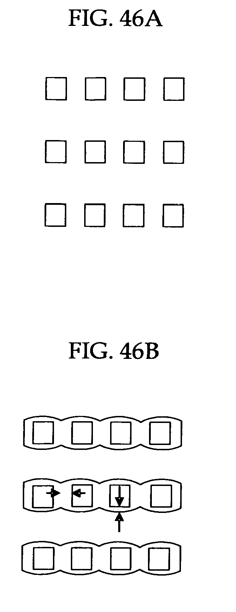

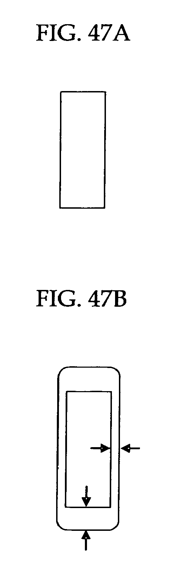

This is explained herein with reference to FIGs. 46A-47B. FIG. 46A shows the resist pattern having an uneven spacing. Namely, the resist pattern shown in FIG. 46A has a region where elements of the resist pattern are sparsely located to each other, i.e. a region where a space between the elements of the resist pattern is wide, and a region where the elements of the resist pattern are closely located to each other, i.e. a region where a space between the elements of the resist pattern is narrow. In this specification, "an element of a resist pattern" generally means a single pattern forming a resist pattern that is comprised of plural patterns. When the resist pattern shown in FIG. 46A is thickened, the thickening amount is small in the region where the elements of the resist pattern are sparsely located to each other, and the thickening amount is large in the region where the elements of the resist pattern are closely located to each other, as shown in FIG. 46B. When a rectangular shaped resist pattern as shown in FIG. 47A is thickened, the thickening amount becomes large along the direction of the wide side compared to the thickening amount along the direction of the narrow side, as shown in FIG. 47B.

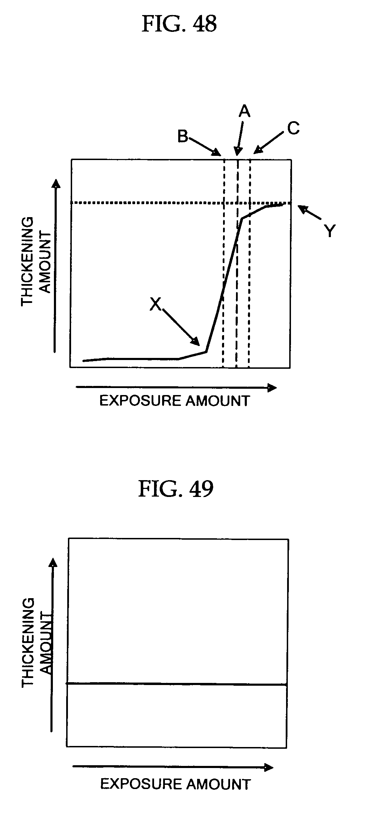

FIG. 48 shows a relationship between an exposure amount (amount of exposure dose on the area around the pattern) at the time of patterning and a thickening amount of the resist pattern. As shown in FIG. 48, the amount of exposure dose on the area around the pattern is smaller in the region where the elements of the resist pattern are sparsely located to each other or along the direction of the narrow side (refer to B in FIG. 48), and the amount of exposure dose on the area around the pattern is larger in the region where the elements of the resist pattern are closely located to each other or along the direction of a wide side (refer to C in FIG. 48), thus the thickening amount varies due to the variations in the amount of exposure dose on the area around the pattern. Therefore, the resist pattern shows uneven developing result depending on the spacing and/or direction of the resist pattern. The thickening amount is largely increased around a certain exposure amount. When this exposure amount for raising the thickening amount is close to the patterning-exposure amount (refer to A in FIG. 48), variations in the exposure amount cause large variations in the thickening amount. The thickening effect of the resist pattern thickening material is generally affected by an acid concentration in the exposed region of the resist patterns. In the art, the resist composition contains photoacid generator and the acid is generated in the exposed region, for example, by an exposure of a light. Accordingly, the increase of the thickening amount is normally occurred around the exposure amount, and thus the thickening amount largely varies depending on the configuration of the resist pattern. To solve this problem, the exposure dose can be adjusted so as to be far from the exposure amount for increasing the thickening amount (refer to X in FIG. 48).

Note that, the thickening amount of the resist pattern does not exceed an initial film thickness of the resist pattern thickening material (refer to Y in FIG. 48).

Also, conventionally, high resolution of the resist pattern has been achieved by adding a base compound, i.e. a quencher. The quencher controls a dispersion of an acid generated from a photoacid generator by exposure in the resist pattern. The compound used for such quencher, which is generally selected from tetraalkyl ammonium hydroxide, amines, and the like, is liable to cause various problems, such as dependency to a size of a resist pattern, and the like, when a commercially available resist composition containing the aforementioned compound is used in combination with a commercially available resist pattern thickening material. The base compound used for the quencher hardly controls a dispersion of an acid to the resist pattern thickening material, and thus it cannot control a reaction between the resist pattern and the resist pattern thickening material.

In summary, in the conventional technique using RELACS material over a KrF or a novolak resist pattern, ArF excimer laser light cannot be used as the light source of an exposure device for patterning due to the strong absorption of the exposure light by the KrF resist. Also, conventional ArF resist pattern or the like cannot be sufficently thickened by the aforementioned resist swelling material used in the RELACS technique. Also, it would be difficult to form a fine space pattern or a wiring pattern at a low cost applying electron beam or X-ray exposures. Therefore, it is desired to improve the RELACS technique.

The present invention aims at solving the shortcomings in the prior art, and achieving the following objects.

An object of the present invention is to provide a resist composition, which can utilize ArF excimer laser light as an exposure light in patterning; and which forms, as a result of exposure and developing, such a resist pattern that is suitable for thickening by applying a resist pattern thickening material over the surface thereof, is uniformly thickened without being affected by the direction and/or spacing variations of the resist pattern, components of the resist pattern thickening material and the like, and is able to form a fine space pattern exceeding exposure or resolution limits of a light source of an exposure device with efficiency and simple procedure at low cost.

Another object of the present invention is to provide a method for forming a resist pattern which, in patterning a resist pattern, can utilize ArF excimer laser light as a light source; which can uniformly thicken a resist pattern without being affected by the direction and/or spacing variations of the resist pattern, components of the resist pattern thickening material and the like; and which is suitable for forming a fine space pattern exceeding exposure or resolution limits of a light source of an exposure device with efficiency and simple procedure at low cost.

Yet another object of the present invention is to provide a method for manufacturing a semiconductor device which, in patterning a resist pattern, can utilize ArF excimer laser light as a light source; which can uniformly thicken a resist pattern without being affected by the direction and/ or spacing variations of the resist pattern, components of the resist pattern thickening material and the like; which is suitable for forming a fine space pattern exceeding exposure or resolution limits of a light source of an exposure device with efficiency and simple procedure at low cost; and which is able to efficiently mass-produce high-performance semiconductors each having a fine wiring pattern formed by using the fine space pattern, as well as to provide a high-performance semiconductor which is manufactured by the method for manufacturing a semiconductor device and which has fine wiring patterns.

### SUMMARY OF THE INVENTION

In view of the aforementioned shortcomings, the inventors of the present invention have investigated vigorously, and have found that when ammonium sulfonate is contained in the resist composition, the resist composition and the resist pattern thickening material interact regardless of the amount of the exposure dose, and thus the resist pattern is desirably and uniformly thickened without being affected by the direction and/or spacing variations of the resist pattern, components of the resist pattern thickening material, and the like.

The present invention is based on such experiences or discoveries. The resist composition of the present invention includes ammonium sulfonates. When the resist composition of the present invention is used to form a resist pattern and the formed resist pattern is thickened by using a resist pattern thickening material, the resist pattern is desirably and uniformly thickened without being affected by the direction and/or spacing variations of the resist pattern, components of the resist pattern thickening material, and the like.

As explained above, a resist pattern formed from a conventional resist composition is thickened by using a resist pattern thickening material, a thickening amount of the resist pattern largely varies depending on the direction and/or space variations of the resist pattern. However, in case of the present invention, when the resist pattern thickening material is applied over a resist pattern formed from the resist composition of the present invention, the portions of the applied resist pattern thickening material in a vicinity of the interface between the resist pattern infiltrate into the resist pattern, and cause an interaction, i.e., mixing, with the resist composition. Then, as the ammonium sulfonate induces the aforementioned interaction regardless of an amount of exposure dose near the pattern, a surface layer or mixing layer, where the resist pattern thickening material and the resist pattern are mixed, is efficiently formed on the surface of the resist pattern as an inner layer. As a result, the resist pattern is efficiently thickened by the resist pattern thickening material. The resist pattern thickened in this way (hereinafter sometimes referring to as "thickened resist pattern") has been thickened uniformly by the resist pattern thickening material. Thus, a space pattern formed by the thickened resist pattern has a fine structure, exceeding exposure or resolution limits. The term "space pattern" generally means, in the specification of the present invention, a hole, trench, recess, or any other empty space that is formed by the resist pattern. Thus, the resist composition of the present invention can be utilized for forming a resist pattern, such as a lines and spaces pattern, on a wiring layer of LOGIC LSI where various sizes of resist patterns are utilized.

The method for forming a resist pattern of the present invention includes: forming a resist pattern from the resist composition of the present invention; and applying a resist pattern thickening material over the resist pattern so as to cover the surface of the resist pattern.

In the method of the present invention, a resist pattern is formed from the resist composition of the present invention and then, when the resist pattern thickening material is applied over the formed resist pattern, the portions of the applied resist pattern thickening material in a vicinity of the interface between the resist pattern infiltrate into the resist pattern, and cause an interaction or mixing with the resist composition. Thus, a surface layer or mixing layer, where the resist pattern thickening material and the resist pattern are mixed, is formed on the surface of the resist pattern as the inner layer. In this way, the resist pattern is uniformly thickened by the resist pattern thickening material. Thus, the space pattern formed by the thickened resist pattern has a fine structure, exceeding exposure or resolution limits. Since the resist composition contains the ammonium sulfonate, the resist pattern formed from the resist composition of the present invention is desirably and uniformly thickened without being affected by the direction and/or spacing variations of the resist pattern, components of the resist pattern thickening material, and the like. The thickening of the resist pattern does not have any dependency to the direction and/or spacing variations of the resist pattern, components of the resist pattern thickening material, and the like. Thus, the method for forming a resist pattern can be suitably utilized for forming a resist pattern, such as a line-space pattern, on a wiring layer of LOGIC LSI where not only a contact hole pattern, but also various sizes of resist patterns are utilized.

The method for manufacturing a semiconductor device of the present invention includes: forming, on a surface of a workpiece, a resist pattern with the resist composition of the present invention; applying a resist pattern thickening material over the resist pattern so as to cover a surface of the resist pattern to thereby thicken the resist pattern; and etching the surface of the workpiece using the thickened resist pattern as a mask so as to pattern the surface of the workpiece.

In the method for forming a semiconductor device of the present invention, a resist pattern is formed from the resist composition of the invention on a surface of a workpiece serving as a subject on which wiring patterns, etc., are formed, and then the resist pattern thickening material is applied over the resist pattern so as to cover the surface of the resist pattern. Then, the portions of the applied resist pattern thickening material in a vicinity of the interface between the resist pattern and the resist pattern thickening material infiltrate into the resist pattern, and cause an interaction or mixing with the resist composition. Thus, a surface layer or mixing layer, where the resist pattern thickening material and the resist pattern are mixed, is formed on the surface of the resist pattern as the inner layer. In this way, the resist pattern is uniformly thickened by the resist pattern thickening material. Thus, the space pattern formed by the thickened resist pattern has a fine structure, exceeding exposure or resolution limits. Since the resist pattern thickening material contains the ammonium sulfonate, the resist pattern formed from the resist composition is desirably and uniformly thickened without being affected by the direction and/or spacing variations of the resist pattern, components of the resist pattern thickening material, and the like. The thickening of the resist pattern does not have any dependency to the direction and/or spacing variations of the resist pattern, components of the resist pattern thickening material, and the like. Thus, thickened resist patterns such as a line-space pattern can be easily and precisely formed on a wiring layer of LOGIC LSI where not only a contact hole pattern, but also various sizes of resist patterns are utilized.

Subsequently, by etching the surface of the workpiece using the thickened resist pattern as a mask, the surface of the workpiece is patterned finely and precisely with accurate dimension, thus high-quality and high performance semiconductor devices can be produced efficiently having a wiring pattern with fine, precise, and accurate dimension.

The semiconductor device of the present invention is manufactured by the method for manufacturing a semiconductor device of the present invention. The semiconductor device has patterns, for example, wiring patterns, with fine, precise, and accurate dimension, and is of high quality and of high performance.

### BRIEF DESCRIPTION OF THE DRAWINGS

FIG. 1 is a schematic diagram for explaining one example of the mechanism of thickening a resist pattern, which is formed from the resist composition of the present invention, by using a resist pattern thickening material, and showing the state where the resist pattern thickening material is applied over the surface of the resist pattern.
FIG. 2 is a schematic diagram for explaining one example of the mechanism of thickening a resist pattern, which is formed from the resist composition of the present invention, by using a resist pattern thickening material, and showing the state where the resist pattern thickening material infiltrates into the surface of the resist pattern.
FIG. 3 is a schematic diagram for explaining one example of the mechanism of thickening a resist pattern, which is formed from the resist composition of the present invention, by using a resist pattern thickening material, and showing the state where the resist pattern is thickened by the resist pattern thickening material.
FIG. 4 is a schematic diagram for explaining an example of a method for forming a resist pattern of the present invention, and showing the state where a resist film is formed.
FIG. 5 is a schematic diagram for explaining an example of a method for forming a resist pattern of the present invention, and showing the state where the resist film is subjected to a patterning, thereby forming a resist pattern.
FIG. 6 is a schematic diagram for explaining an example of a method for forming a resist pattern of the present invention, and showing the state where the resist pattern thickening material is applied over the surface of the resist pattern.
FIG. 7 is a schematic diagram for explaining an example of a method for forming a resist pattern of the present invention, and showing the state where a mixing is occurred at the vicinity of the interface between the surface of the resist pattern and the resist pattern thickening material, and the resist pattern thickening material infiltrates into the resist pattern.
FIG. 8 is a schematic diagram for explaining an example of a method for forming a resist pattern of the present invention, and showing the state where the resist pattern thickening material is developed.
FIG. 9 is a schematic diagram for explaining an example of a method for manufacturing a semiconductor device of the present invention, and showing the state where an interlayer dielectric film is formed on a silicon substrate.
FIG. 10 is a schematic diagram for explaining an example of a method for manufacturing a semiconductor device of the present invention, and showing the state where a titanium film is formed on the interlayer dielectric film.
FIG. 11 is a schematic diagram for explaining an example of a method for manufacturing a semiconductor device of the present invention, and showing the state where a resist film is formed on the titanium film and a hole pattern is formed on the titanium film.
FIG. 12 is a schematic diagram for explaining an example of a method for manufacturing a semiconductor device of the present invention, and showing the state where the hole pattern is also formed on the titanium film.
FIG. 13 is a schematic diagram for explaining an example of a method for manufacturing a semiconductor device of the present invention, and showing the state where a Cu film is formed on the interlayer dielectric film having the hole pattern.
FIG. 14 is a schematic diagram for explaining an example of a method for manufacturing a semiconductor device of the present invention, and showing the state where the copper is removed except the layer on the hole pattern of the interlayer dielectric film.
FIG. 15 is a schematic diagram for explaining an example of a method for manufacturing a semiconductor device of the present invention, and showing the state where an interlayer dielectric film is formed on the Cu plug formed inside of the hole pattern, and on the interlayer dielectric film.
FIG. 16 is a schematic diagram for explaining an example of a method for manufacturing a semiconductor device of the present invention, and showing the state where a hole pattern is formed on the interlayer dielectric film as a surface layer and a Cu plug is formed therein.
FIG. 17 is a schematic diagram for explaining an example of a method for manufacturing a semiconductor device of the present invention, and showing the state where a three-layered wiring is formed.
FIG. 18 is a top view for explaining a FLASH EPROM which is one example of a semiconductor device of the present invention.
FIG. 19 is a top view for explaining a FLASH EPROM which is another example of a semiconductor device of the present invention.
FIG. 20 is a cross-sectional schematic diagram for explaining a method for manufacturing the FLASH EPROM which is an example of the method for manufacturing a semiconductor device of the present invention.
FIG. 21 is a cross-sectional schematic diagram for explaining a method for manufacturing the FLASH EPROM which is an example of the method for manufacturing a semiconductor device of the present invention, and showing a step after the step shown in FIG. 20.
FIG. 22 is a cross-sectional schematic diagram for explaining a method for manufacturing the FLASH EPROM which is an example of the method for manufacturing a semiconductor device of the present invention, and showing a step after the step shown in FIG. 21.
FIG. 23 is a cross-sectional schematic diagram for explaining a method for manufacturing the FLASH EPROM which is an example of the method for manufacturing a semiconductor device of the present invention, and showing a step after the step shown in FIG. 22.
FIG. 24 is a cross-sectional schematic diagram for explaining a method for manufacturing the FLASH EPROM which is an example of the method for manufacturing a semiconductor device of the present invention, and showing a step after the step shown in FIG. 23.
FIG. 25 is a cross-sectional schematic diagram for explaining a method for manufacturing the FLASH EPROM which is an example of the method for manufacturing a semiconductor device of the present invention, and showing a step after the step shown in FIG. 24.
FIG. 26 is a cross-sectional schematic diagram for explaining a method for manufacturing the FLASH EPROM which is an example of the method for manufacturing a semiconductor device of the present invention, and showing a step after the step shown in FIG. 25.
FIG. 27 is a cross-sectional schematic diagram for explaining a method for manufacturing the FLASH EPROM which is an example of the method for manufacturing a semiconductor device of the present invention, and showing a step after the step shown in FIG. 26.
FIG. 28 is a cross-sectional schematic diagram for explaining a method for manufacturing the FLASH EPROM which is an example of the method for manufacturing a semiconductor device of the present invention, and showing a step after the step shown in FIG. 27.
FIG. 29 is a cross-sectional schematic diagram for explaining the method for manufacturing the FLASH EPROM which is another example of the method for manufacturing a semiconductor device of the present invention.
FIG. 30 is a cross-sectional schematic diagram for explaining the method for manufacturing the FLASH EPROM which is another example of the method for manufacturing a semiconductor device of the present invention, and showing a step after the step shown in FIG. 29.
FIG. 31 is a cross-sectional schematic diagram for explaining the method for manufacturing the FLASH EPROM which is another example of the method for manufacturing a semiconductor device of the present invention, and showing a step after the step shown in FIG. 30.
FIG. 32 is a cross-sectional schematic diagram for explaining the method for manufacturing the FLASH EPROM which is yet another example of the method for manufacturing a semiconductor device of the present invention.
FIG. 33 is a cross-sectional schematic diagram for explaining the method for manufacturing the FLASH EPROM which is yet another example of the method for manufacturing a semiconductor device of the present invention, and showing a step after the step shown in FIG. 32.
FIG. 34 is a cross-sectional schematic diagram for explaining the method for manufacturing the FLASH EPROM which is yet another example of the method for manufacturing a semiconductor device of the present invention, and showing a step after the step shown in FIG. 33.
FIG. 35 is a cross-sectional schematic diagram for explaining an example in which a resist pattern formed from the resist composition of the present invention, which has been thickened by using the resist pattern thickening material, is applied to the manufacturing of a recording head.
FIG. 36 is a cross-sectional schematic diagram for explaining an example in which a resist pattern formed from the resist composition of the present invention, which has been thickened by using the resist pattern thickening material, is applied to the manufacturing of a recording head, and showing a step after the step shown in FIG. 35.
FIG. 37 is a cross-sectional schematic diagram for explaining an example in which a resist pattern formed from the resist composition of the present invention, which has been thickened by using the resist pattern thickening material, is applied to the manufacturing of a recording head, and showing a step after the step shown in FIG. 36.
FIG. 38 is a cross-sectional schematic diagram for explaining an example in which a resist pattern formed from the resist composition of the present invention, which has been thickened by using the resist pattern thickening material, is applied to the manufacturing of a recording head, and showing a step after the step shown in FIG. 37.
FIG. 39 is a cross-sectional schematic diagram for explaining an example in which a resist pattern formed from the resist composition of the present invention, which has been thickened by using the resist pattern thickening material, is applied to the manufacturing of a recording head, and showing a step after the step shown in FIG. 38.
FIG. 40 is a cross-sectional schematic diagram for explaining an example in which a resist pattern formed from the resist composition of the present invention, which has been thickened by using the resist pattern thickening material, is applied to the manufacturing of a recording head, and showing a step after the step shown in FIG. 39.
FIG. 41 is a cross-sectional schematic diagram for explaining an example in which a resist pattern formed from the resist composition of the present invention, which has been thickened by using the resist pattern thickening material of the present invention, is applied to the manufacturing of a recording head, and showing a step after the step shown in FIG. 40.
FIG. 42 is a cross-sectional schematic diagram for explaining an example in which a resist pattern formed from the resist composition of the present invention, which has been thickened by using the resist pattern thickening material of the present invention, is applied to the manufacturing of a recording head, and showing a step after the step shown in FIG. 41.
FIG. 43 is a cross-sectional schematic diagram for explaining an example in which a resist pattern formed from the resist composition of the present invention, which has been thickened by using the resist pattern thickening material of the present invention, is applied to the manufacturing of a recording head, and showing a step after the step shown in FIG. 42.
FIG. 44 is a cross-sectional schematic diagram for explaining an example in which a resist pattern formed from the resist composition of the present invention, which has been thickened by using the resist pattern thickening material of the present invention, is applied to the manufacturing of a recording head, and showing a step after the step shown in FIG. 43.
FIG. 45 is a plan view showing an example of the recording head manufactured by the steps of FIGs. 35 through 44.
FIG. 46A is a schematic diagram for showing an example of a resist pattern having spacing variations, and FIG. 46B is a schematic diagram for showing a state where the resist pattern is thickened.
FIG. 47A is a schematic diagram for showing an example of a rectangular resist pattern, and FIG. 47B is a schematic diagram for showing a state where the rectangular resist pattern is thickened.
FIG. 48 is a graph showing an example of a relationship between an exposure amount and a thickening amount when a thickening is conducted on a conventional resist pattern.
FIG. 49 is a graph showing an example of a relationship between an exposure amount and a thickening amount when a thickening is conducted on a resist pattern formed from a non-photosensitive resin added with ammonium sulfonate.
FIG. 50 is a schematic diagram for showing an example of a relationship between an exposure amount and a thickening amount when a thickening is conducted on a resin pattern formed from the resist composition of the present invention.
FIG. 51 is a graph showing an example of a relationship between an exposure amount and a thickening amount when a thickening is conducted on a resin pattern formed from the resist composition of the present invention.
FIG. 52A is a schematic diagram showing a resist pattern before thickening in Example 1, and FIG. 52B is a schematic diagram showing a resist pattern after thickening in Example 1.
FIG. 53 is a schematic diagram showing a resist pattern before thickening in Example 3.

### DESCRIPTION OF THE PREFERRED EMBODIMENTS

The present invention provides a resist composition comprising a resist material and ammonium sulfate.

The resist material of the present invention can be generally used in chemically amplified resist systems. The resist material can comprise a resin, photoacid generator(s), quencher(s) and surfactant(s), and may further comprise other substances, if necessary.

Once a resist pattern is formed from the resist composition of the present invention and a resist pattern thickening material, which is described later, is applied over the formed resist pattern, the portions of the applied resist pattern thickening material in a vicinity of the interface between the resist pattern thickening material and the resist pattern infiltrate into the resist pattern and cause an interaction, i.e., mixing, with the resist composition. As the ammonium sulfonate is highly reactive with the resist pattern thickening material, a surface layer or mixing layer, where the resist pattern thickening material and the resist pattern are mixed, is efficiently formed on the surface of the resist pattern as an inner layer. As a result, the resist pattern is efficiently thickened by the resist pattern thickening material. The resist pattern thickened in this way (hereinafter sometimes referring to as "thickened resist pattern") is uniformly thickened by the resist pattern thickening material. Thus, a space pattern formed by the thickened resist pattern has a fine structure, exceeding exposure limits or resolution limits.

Since the resist composition of the present invention comprises the ammonium sulfonate, the resist composition has a desirable and uniform thickening effect regardless of components of the resist pattern thickening material. Moreover, the resist composition is rarely affected by the size, spacing variations, and/or direction of the resist pattern, components the resist pattern thickening material, and the like.

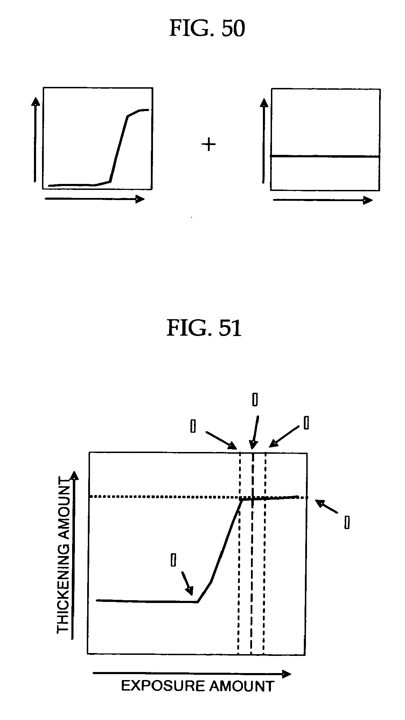

The resist pattern thickening material generally comprises a resin. Thus, the ammonium sulfonate contained in the resist composition induces an interaction (reaction) between the resist pattern thickening material and the resist composition so that the resist pattern formed from the resist composition is thickened, and the aforementioned interaction is not affected by an exposure amount during the patterning process. FIG. 49 shows a relationship between the exposure amount and the thickening amount when a resist pattern is formed from a non-photosensitive composition added with the ammonium sulfonate, and is thickened by using a resist pattern thickening material. As shown in FIG. 49, the ammonium sulfonate exhibits a certain thickening effect independent from the variations of the exposure amount. FIG. 50 shows a relationship between the exposure amount and the thickening amount when a resist pattern is formed from the resist composition comprising the ammonium sulfonate. As shown in FIG. 50, the thickening amount of the resist pattern is a sum of an ordinary thickening amount due to an exposure amount and a thickening amount due to the ammonium sulfonate which is unrelated to the exposure amount. Note that the maximum thickening amount does not exceed the initial film thickness of the resist pattern thickening material. As a result, the exposure amount for raising the thickening amount can be set far from the patterning exposure amount, thereby reducing the variations of the thickening amount.

### (Ammonium Sulfonate)

As explained above, the resist composition comprises an ammonium sulfate. The ammonium sulfonate can be appropriately selected in accordance with the purpose. Since the ammonium sulfonate is neutral and a usage amount thereof to the resist composition is small, the ammonium sulfonate does not adversely affect on the functions of the resist performance.

The ammonium sulfonate comprises a sulfonium moiety and an ammonium moiety.

The sulfonium moiety can be appropriately selected in accordance with the purpose. In view of easiness of synthesis or availability, the sulfonium moiety can be derived from a trifluoromethanesulfonic acid, a toluenesulfonic acid , or the like, i.e. a trifluoromethanesulfonic acid anion, a *p*-toluenesulfonic acid anion. In the case that the resist composition comprises one or more ammonium sulfonates, the sulfonium moieties are mutually same or different, can be selected from the above-listed ions.

The ammonium moiety can be appropriately selected in accordance with the purpose. The ammonium moiety can be a primary ammonium cation, a secondary ammonium cation, a tertiary ammonium cation, or the like. In the case that the resist composition comprises one or more ammonium sulfonates, the ammonium moieties are mutually same or different, and can be selected from the above-listed ions. If the ammonium moiety is selected from an ammonium cation (NH₄⁺) and a quaternary ammonium cation, e.g. tetramethyl ammonium cation, tetraethyl ammonium cation, or the like, the resist composition does not react or significantly reduce its reactivity with a resist pattern thickening material.

The ammonium moiety can be the ion expressed by Formula 1 below in view of easiness of synthesis, availability, and desirable reactivity.

N⁺R¹R²R³R⁴ Formula 1

In Formula 1, N is a nitrogen atom, at least one of R¹ to R⁴ is a hydrogen atom, and the others are selected from the group consisting of a C₁₋₄ alkyl group and a phenyl group.

Specific examples of the ammonium sulfonate are triethylammonium *p*-toluenesulfonate, methylphenylammonium trifluoromethanesulfonate, dimethylammonium trifluoromethanesulfonate, monoethylammonium *p*-toluenesulfonate, and the like. One or a combination of these ammonium sulfonates can be used in the resin composition of the present invention.

The content of the ammonium sulfonate in the resist composition can be appropriately adjusted in accordance with the purpose. The content of the ammonium sulfonate can be 0.01% by mass to 5% by mass in one embodiment, and can be 0.05% by mass to 2% by mass in another embodiment, with respect to the total solids mass of the resist composition.

In the case that the content is less than the lower limit with respect to the total solids mass of the resist composition, the resist pattern may have an insufficient reactivity with a resist pattern thickening material. In the case that the content is more than the upper limit with respect to the total solids mass of the resist composition, the functions of the resist composition may be deteriorated due to precipitation of the salts.

The ammonium sulfonate is either added in the process of preparing a resist composition or mixed with a commercially available resist composition. The presence of the ammonium sulfonate in the resist composition is confirmed, for example, by liquid chromatography, but means for confirming the presence thereof is not necessary limited thereto.

### (Resist Material)

The resist material of the present invention can be appropriately selected in accordance with the purpose, provided that the resist material and the ammonium sulfonate form the resist composition of the present invention. The resist composition can have a sensitivity to an exposure light having wavelength of 440 nm or shorter so that the resist composition can be subjected to exposure which uses the exposure light having a wavelength of 440 nm or shorter as an exposure source.

The exposure light can be appropriately selected in accordance with the purpose, provided that it has a wavelength of 440 nm or shorter. Examples of the exposure light can be a g-ray (436 nm), an i-ray (365 nm), a KrF eximer laser light (248 nm), an ArF eximer laser light (193 nm), an F₂ eximer laser light (157 nm), an electron beam, and the like.

The resist composition can include a resist material which is patternable by the exposure light, which can be selected from the known negative or positive resist materials. Examples of the resist materials can include a g-ray resist, an i-ray resist, a KrF resist, an ArF resist, an F₂ resist, an electron beam resist, and the like. These are either chemically amplified resists or non-chemically amplified resists. Among these examples, a KrF resist, an ArF resist and a resist comprising an acrylic resin can be generally used. In view of fine patterning and improvements of throughput, the ArF resist which is desired to extend the exposure limit thereof, and the resist comprising an acrylic resin are more preferable.

The ArF resist can be appropriately selected in accordance with the purpose. The ArF resist can be an alicyclic resist.

Examples of the alicyclic resist are an acrylic resist comprising an acryl resin having an alicyclic functional group at a side chain thereof, a cycloolefin-maleic acid anhydride (COMA) resist, a cycloolefin resist, a hybrid resist, e.g. alicyclic acryl-COMA polymer resist, and the like. These resins can be modified with fluorine.

The alicyclic functional group can be appropriately selected in accordance with the purpose. The alicyclic functional group can be an adamantyl group, a norbornyl group, or the like. The cycloolefin resist can be a resist comprising cycloolefin containing adamantane, norbornane, tricyclononane or the like in its main chain.

### (Method for Forming Resist Pattern)

A forming method, size, thickness or the like of the resist pattern can be appropriately selected in accordance with the purpose. The thickness of the resist pattern is appropriately adjusted in accordance with a surface of a workpiece serving as a working subject, conditions of etching, or the like, but the thickness thereof is generally 0.2 µm to 700 µm.

The thickening of the resist pattern by using the resist pattern thickening material is explained hereinafter with reference to figures.

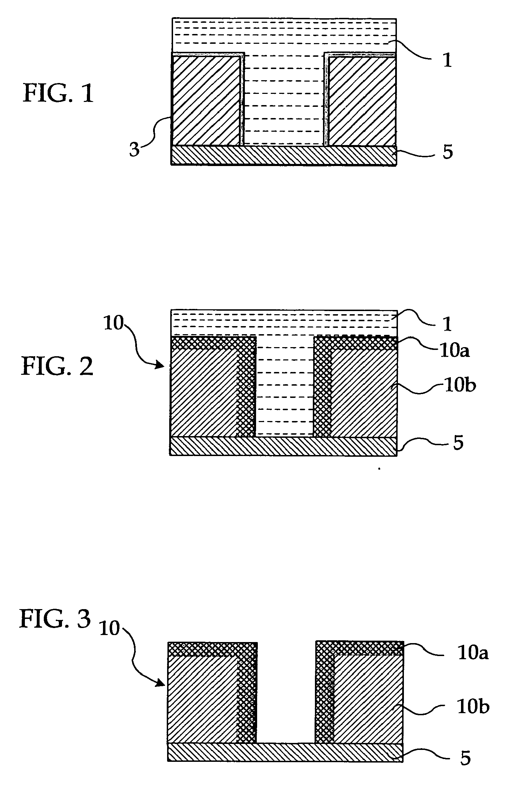

As shown in FIG. 1, after a resist pattern 3 has been formed from the resist composition of the present invention on a surface of a workpiece (base material) 5, a resist pattern thickening material 1 is applied (coated) over the surface of the resist pattern 3. Prebaking (heating and drying) is carried out, such that a coated film is formed. Subsequently, the resist film was exposed by the exposure light through an appropriate mask pattern. The exposed film was subjected to bake, develop in an alkaline developer, and to rinse in deionized water. Then, the resist pattern thickening material was coated onto the resist pattern and baked. Mixing or infiltrating of the resist pattern thickening material 1 into the resist pattern 3 occurs at the interface between the resist pattern 3 and the resist pattern thickening material 1. As shown in FIG. 2, a surface layer or mixing layer 10a is formed as the result of reaction of the mixed or infiltrated portions at the interface of an inner layer resist pattern 10b (the resist pattern 3) and the resist pattern thickening material 1. At this time, since the resist composition of the present invention comprises the ammonium sulfonate, the inner layer resist pattern 10b (the resist pattern 3) is efficiently and uniformly thickened without being affected by the direction and/or spacing variations of the inner layer resist pattern 10b (the resist pattern 3).

Thereafter, as shown in FIG. 3, by carrying out a developing, the portions with no interaction or mixing with the resist pattern 3 or portions with less interaction or mixing with the resist pattern 3, i.e., the portions having high water-solubility, in the resist pattern thickening material 1 coated on the resist pattern 3, are dissolved and removed, and therefore a thickened resist pattern 10, which has been uniformly thickened, is developed or formed.

The developing can be performed with water or an alkaline developer.

The thickened resist pattern 10 has, on the surface of the inner layer resist pattern 10b (the resist pattern 3), the surface layer 10a which has been formed as a result of mixing or infiltrating of the resist pattern thickening material 1. Since the thickened resist pattern 10 is thicker than the resist pattern 3 by an amount corresponding to the thickness of the surface layer 10a, the size of space pattern formed by the thickened resist pattern, i.e., the distance between adjacent elements of the thickened resist pattern 10 or opening diameter of the hole pattern formed by the thickened resist pattern 10, is smaller than that formed by the resist pattern 3 prior to thickening. Thus, the space pattern formed by the resist pattern exceeds exposure or resolution limits of a light source of the exposure device upon forming the resist pattern 3. Accordingly, when patterning a resist pattern by means of ArF excimer laser light, and thickening the resist pattern by means of the resist pattern thickening material, the space pattern formed by the thickened resist pattern can represent such fine conditions as those patterned by an electron beam. The space pattern formed by the thickened resist pattern 10 is finer and more precise than the space pattern formed by the resist pattern 3.

Since the resist composition of the present invention comprises the ammonium sulfonate, the resist composition of the present invention is suitably used for forming a resist pattern, which is coated with the resist pattern thickening material and is thickened. In addition, the resist pattern formed from the resist composition of the present invention is uniformly thickened by using the resist pattern thickening material without being affected by the direction, and/or spacing variations of the resist pattern, components of the resist pattern thickening material and the like, and thus a fine space pattern can be efficiently formed exceeding the exposure or resolution limits of a light source of the available exposure device, at low cost.

The resist composition of the present invention is suitably utilized for a method for forming a resist pattern of the present invention, and a method for manufacturing a semiconductor device of the present invention.

As described above, high resolution and a desirable thickening amount could not conventionally be achieved at the same time. However, when the resist composition of the present invention is applied a reaction or interaction between the resist pattern and a resist pattern thickening material can be controlled without controlling diffusion of an acid, and thus the dependency of thickening effects to the size of the resist pattern can be reduced while achieving high resolution.

Generally, the method for forming a resist pattern of the present invention comprises: forming a resist pattern from the resist composition of the present invention; and applying a resist pattern thickening material over the resist pattern so as to cover a surface of the resist pattern. The method for forming a resist pattern of the present invention can further comprise other steps suitably selected according to necessity.

The details of the resist composition are as described in the descriptions of the resist composition of the present invention above.

The resist pattern can be formed on a surface of a workpiece (base material). The surface of the workpiece (base material) can be appropriately selected in accordance with the purpose. However, when the resist pattern is formed into a semiconductor device, the surface of the workpiece (base material) is, for example, a surface of a semiconductor substrate. Specific examples thereof are the surfaces of the substrate such as a silicon wafer, various types of oxide films, and the like.

The resist pattern thickening material can be appropriately selected from known material in accordance with the purpose, provided that the material thickens a resist pattern as a result of applying thereof over the resist pattern. The resist pattern thickening material is a material comprising a surfactant, a commercially available material, or a material synthesized according to necessity.

The method of applying the resist pattern thickening material can be appropriately selected from known coating methods in accordance with the purpose. Suitable examples are a spin coating method and the like. In the case where a spin coating method is used, the conditions are, for example, as follows: the rotational speed can be about 100 rpm to 10,000 rpm in one embodiment, and can be 800 rpm to 5,000 rpm in another embodiment; and the duration can be about one second to 10 minutes in one embodiment, and can be 1 second to 90 seconds in another embodiment.

The coated thickness at the time of coating can be generally about 10 nm to 1,000 nm (100 angstroms to 10,000 angstroms) in one embodiment, and can be 100 nm to 500 nm (1,000 angstroms to 5,000 angstroms) in another embodiment.

By carrying out prebaking (heating and drying) of the applied resist pattern thickening material during the applying or after the applying, the resist pattern thickening material can be efficiently mixed or infiltrated into the resist pattern at the interface between the resist pattern and the resist pattern thickening material.

The conditions, method, and the like of the prebaking (heating and drying) can be selected such that a softening of the resist pattern is not caused, and they can be appropriately selected in accordance with the purpose. For example, the prebaking can be carried out once, or two or more times. When the prebaking is carried out two or more times, the temperature of prebaking at each time may be constant or may be different. When the temperature is constant, the temperature can be about 40°C to 150°C in one embodiment, and can be 70°C to 120°C in another embodiment, and the duration can be about 10 seconds to 5 minutes in one embodiment, and can be 40 seconds to 100 seconds in another embodiment.

Moreover, if necessary, the applied resist pattern thickening material after the prebaking (heating and drying) can be baked from the standpoint that the mixing or infiltrating at the interface of the resist pattern and the resist pattern thickening material can be made to proceed efficiently.

The conditions, method, and the like of the baking can be appropriately selected in accordance with the purpose. However, a higher temperature than that at the prebaking (heating and drying) is usually used. The conditions of the baking are, for example, that the temperature can be about 70°C to 150°C in one embodiment, and can be 90°C to 130°C in another embodiment, and the duration can be about 10 seconds to 5 minutes in one embodiment, and can be 40 seconds to 100 seconds in another embodiment.

Moreover, a developing can be performed on the applied resist pattern thickening material after the baking. In this case, the developing is advantageous in that, the portions with no interaction or mixing with the resist pattern, or the portions with less interaction or mixing with the resist pattern, i.e., the portions having high water-solubility, in the applied resist pattern thickening material, are dissolved and removed, and thus a thickened resist pattern is developed or obtained.

The developing can be performed with water or an alkaline developer. In view of low cost and efficiency, water developing can be generally performed.

The resist pattern thickening material is applied over the resist pattern, and is allowed to interact (mix) with the resist pattern to thereby form, on the surface of the resist pattern, a layer (mixing layer) resulted from the interaction (mixing) between the resist pattern thickening material and the resist pattern. As a result, the resist pattern is thickened by an amount corresponding to the thickness of the mixing layer, and the thickened resist pattern is formed.

The diameter or width of the space pattern formed by the thickened resist pattern is reduced from the diameter or width of the space pattern formed by the resist pattern before thickening. As a result, the fine space pattern is formed exceeding the exposure or resolution limits of a light source of the exposure device used at the time of patterning the resist pattern. In other words, the space pattern such as the opening diameter or space width is smaller than the opening diameter or space width patternable by the wavelength of the light as the light source. Specifically, if the resist pattern is formed by using ArF eximer laser light at the time of patterning and the resist pattern is thickened by using the resist pattern thickening material, the space pattern formed by the thus thickened resist pattern is as fine and specific as a space pattern patterned by using electron beam.

The thickening amount of the resist pattern is controlled at the predetermined amount by appropriately controlling a viscosity and applied thickness of the resist pattern thickening material, baking temperature, baking duration, and the like.

According to the present invention, the pattern size variation can be limited less than 20nm in one embodiment, and less than 15nm in another embodiment. In the present invention, the term "pattern size variation" generally means a difference of the sizes in the narrow side and wide side, or of the width and length, of an element of a resist pattern.

The method for forming a resist pattern of the present invention will be described hereinafter with reference to the drawings.

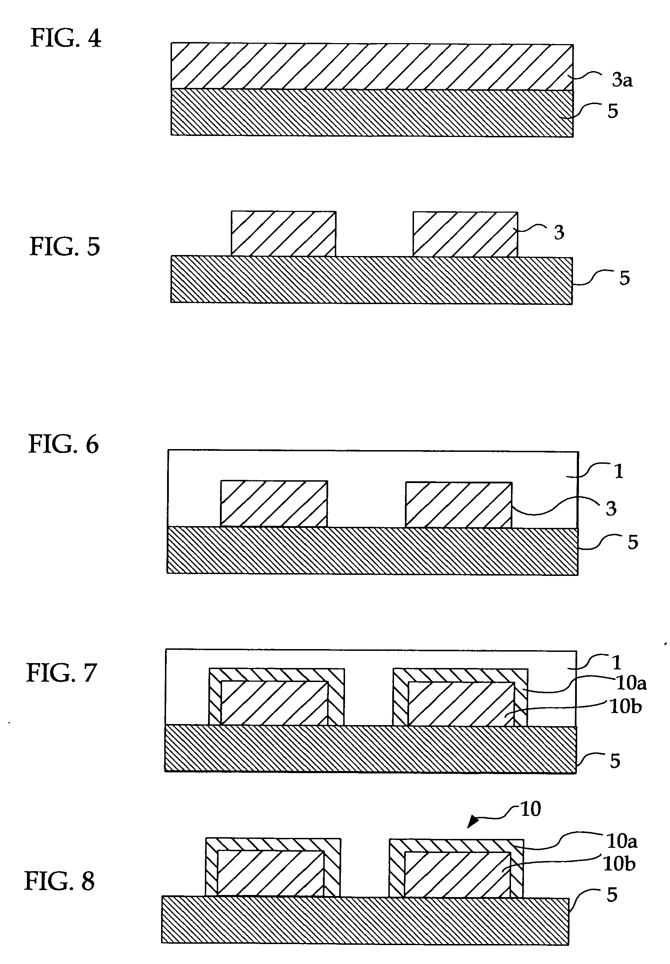

As shown in FIG. 4, a resist composition of the present invention 3a is coated on a surface of a workpiece (base material) 5. Then, as shown in FIG. 5, the resist composition 3a is patterned to form the resist pattern 3. Thereafter, as shown in FIG. 6, the resist pattern thickening material 1 is applied over the surface of the resist pattern 3, and prebaking (heating and drying) is carried out to form a coated film. Then, mixing or infiltrating of the resist pattern thickening material 1 into the resist pattern 3 takes place at the interface between the resist pattern 3 and the resist pattern thickening material 1. As shown in FIG. 7, mixing or infiltrating portions at the interface between the resist pattern 3 and the resist pattern thickening material 1 further interact or react. Thereafter, as shown in FIG. 8, by carrying out developing, the portions with no reaction or less interaction or mixing with the resist pattern 3, i.e., the portions having high water-solubility, in the applied resist pattern thickening material 1, are dissolved and removed, such that the thickened resist pattern 10 composed of the inner layer resist pattern 10b (the resist pattern 3) and surface layer 10a thereon, is developed or formed.

The thickened resist pattern 10 is formed as a result of thickening of the resist pattern 3 by the resist pattern thickening material 1, and has, on the surface of the inner layer resist pattern 10b (the resist pattern 3), the surface layer 10a formed as a result of reaction with the resist pattern thickening material 1. Upon thickening, since the resist composition 3a comprises the ammonium sulfonate, the inner layer resist pattern 10b (the resist pattern 3) is uniformly thickened without being adversely affected by the direction and/ or spacing variation of the inner layer resist pattern 10b (the resist pattern 3). The thickened resist pattern 10 is thicker than the resist pattern 3 (the inner layer resist pattern 10b) by an amount corresponding to the thickness of the surface layer 10a. Thus, the width of the space pattern formed by the thickened resist pattern 10 is smaller than that of the space pattern formed by the resist pattern 3, and the space pattern formed by the thickened resist pattern 10 is fine.

The method for forming a resist pattern of the present invention is suitable for forming a variety of space patterns, for example, a line-space pattern, hole pattern (e.g., for contact hole), trench (groove) pattern, etc. The thickened resist pattern formed by the method for forming a resist pattern can be used as a mask pattern, reticle pattern and the like, can be applied for manufacturing functional parts such as metal plugs, various wirings, recording heads, LCDs (liquid crystal displays), PDPs (plasma display panels), SAW filters (surface acoustic wave filters), optical parts used in connecting optical wiring, fine parts such as microactuators, semiconductor devices, and the like, and can be suitably employed in the method for manufacturing a semiconductor device of the present invention which will be described hereinafter.

### (Method for Manufacturing Semiconductor Device)

The method for manufacturing a semiconductor device of the present invention comprises: forming a resist pattern from the resist composition of the present invention on a surface of a workpiece; applying a resist pattern thickening material over the resist pattern to thereby thicken the resist pattern; and etching the surface of the workpiece using the thickened resist pattern as a mask so as to pattern the surface of the workpiece. The method for manufacturing a semiconductor device of the present invention can further comprise other steps, if necessary.

The forming is a step of forming a resist pattern from the resist composition of the present invention on a surface of a workpiece, and the applying is a step of applying a resist pattern thickening material over the formed resist pattern to thereby thicken the resist pattern. In this way, the thickened resist pattern is formed on the surface of the workpiece.

Details in the formation of the resist pattern are the same as those of the method for forming a resist pattern of the present invention.

Examples of the surface of the workpiece are surface layers of various members in semiconductor devices. Suitable examples are substrates such as silicon wafers, surface layers thereof, various types of oxide films, and the like. The resist pattern is as described above. The method of coating is as described above. Further, after the coating, the above-described prebaking, baking, and the like can be carried out.

The etching is a step of patterning the surface of the workpiece by carrying out etching using the formed thickened resist pattern as a mask (mask pattern) or the like.

The method of etching can be appropriately selected from among known methods in accordance with the purpose. Dry etching can be used in one embodiment. The etching conditions can be appropriately selected in accordance with the purpose.

Suitable examples of the other steps are a surfactant coating step, a developing step, and the like.

The surfactant coating step is a step for coating the surfactant on the surface of the resist pattern prior to the applying a resist pattern thickening material.

The surfactant can be appropriately selected from cationic surfactants, anionic surfactants, and non-ionic surfactants, which do not contain any metalic atom or ion, in accordance with the purpose. Suitable examples are polyoxyethylene - polyoxypropylene condensation products, polyoxyalkylene alkylether, polyoxyethylene alkylether, polyoxyethylene derivatives, sorbitan fatty acid ester, glycerin fatty acid ester, primary alcohol ethoxylate, phenol ethoxylate, nonylphenol ethoxylate, octylphenol ethoxylate, lauryl alcohol ethoxylate, oleyl alcohol ethoxylate, fatty acid ester, amide, natural alcohol, ethylene diamine, secondary alcohol ethoxylate, alkyl cationic, amide quaternary cationic, ester quaternary cationic, amine oxide, betaine surfactants, and the like.

The developing step is a step for carrying out a developing of the applied resist pattern thickening material after the forming and before the etching. Note that the developing is as described above.

By using the method for manufacturing a semiconductor device of the present invention, it is possible to efficiently manufacture various types of semiconductor devices such as flash memories, DRAMs, FRAMs.

The present invention will be illustrated in further detail with reference to several examples below, which are not intended to limit the scope of the present invention.

### (Example 1)

### -Preparation of Resist Composition-

A resist composition was prepared from 100 parts by mass of a resin mixture (molecular weight of approximately 10,000) of *tert*-butoxycarbonyloxystyrene/*p*-hydroxylstyrene (20/80), 5 parts by mass of triphenylsulfonium nonafluorobutanesulfonate, 1 part by mass of triethylammonium *p*-toluenesulfonate, and 800 parts by mass of ethyl lactate.

### -Forming of Resist Pattern-

Thereby obtained resist composition was spun onto the entire surface of a silicon wafer (available from Mitsubishi Materials Corporation) at 3,500 rpm for 20 seconds, and a prebaking was performed on the coated resist film at 110°C for 120 seconds. KrF eximer laser light was exposed thereon through a mask at a dose of 80 mJ/cm², a baking was performed on the exposed resist film at 110°C for 120 seconds, and then the baked resist film was developed with 2.38% by mass of TMAH aqueous solution for 1 minute to thereby form a resist pattern of single rectangle having a size of 250 nm x 1,000 nm. Note that, the thickness of the thus obtained resist pattern was 500 nm.

On the thus obtained resist pattern, a resist pattern thickening material (AZ R500, available from AZ Electronic Materials) was spin coated at 3,500 rpm for 60 seconds. A baking was performed thereto at 110°C for 60 seconds, and the resist pattern thickening material was rinsed with pure water for 60 seconds so as to remove non-reacted portions where no interaction was occurred, to thereby develop the resist pattern thickened by the resist pattern thickening material. Thus, a thickened resist pattern was formed.

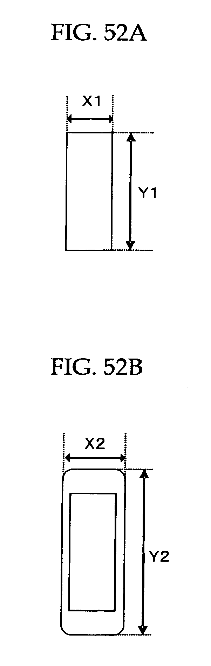

The resist pattern before thickening (the resist pattern) was illustrated in FIG. 52A, and the resist pattern after thickening (the thickened resist pattern) was illustrated in FIG. 52B. The sizes of the narrow side direction, X1 and X2, and the sizes of the wide side direction, Y1 and Y2, were measured, respectively. Thereafter, the variations of the pattern size along the narrow side direction, i.e. X2-X1, and the variations of the pattern size along the wide side direction, i.e. Y2-Y1, were calculated. The variations of the pattern size were 52 nm in the narrow side direction and 55 nm in the wide side direction. Accordingly, it was found that the resist composition of Example 1 was uniformly thickened without being affected by the direction of the resist pattern.

### (Comparative Example 1)

A thickened resist pattern was formed and variations of the pattern size were calculated in the narrow side direction and in the wide side direction, in the same manner of Example 1, provided that triethylammonium *p*-toluenesulfonate was not added in the process of preparing the resist composition. The variations of the pattern size were 15 nm in the narrow side direction, and 35 nm in the wide side direction. Accordingly, it was found that the resist composition of Example 1 without adding triethylammonium *p*-toluenesulfonate as ammonium sulfonate significantly varies the thickening amounts depending on the direction of the resist pattern, and especially the thickening amount along the wide side direction was larger than the thickening amount along the narrow direction.

### (Example 2)

A thickened resist pattern was formed and variations of the pattern size were calculated along the narrow side direction and along the wide side direction, in the same manner of Example 1, provided that the resist composition was prepared from 5 g of KrF resist (DX5200P, available from AZ Electronic Materials), and 3 mg of methylphenylammonium trifluoromethanesulfonate. Note that, the content of the aforementioned ammonium salt was 0.3-0.6% by mass with respect to a mass of the solid content of the KrF resist.

The size variations of the pattern were 59 nm in the narrow side direction and 63 nm in the wide side direction. Accordingly, it was found that the resist composition of Example 2 was uniformly thickened without being affected by the direction of the resist pattern.

### (Comparative Example 2)

A thickened resist pattern was formed and variations of the pattern size were calculated in the narrow side direction and in the wide side direction, in the same manner of Example 2, provided that methylphenylammonium trifluoromethanesulfonate was not added in the process of preparing a resist composition. The variations of the pattern size were 22 nm in the narrow side direction and 53 nm in the wide side direction. Accordingly, it was found that the resist composition of Example 2 without adding methylphenylammonium trifluoromethanesulfonate as ammonium sulfonate significantly varies the thickening amounts depending on the direction of the resist pattern, and especially the thickening amount in the wide side direction was larger than the thickening amount in the narrow direction.

### (Example 3)

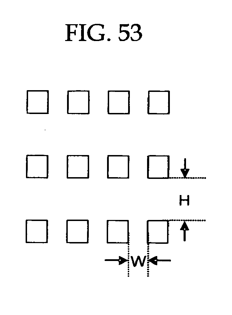

A thickened resist pattern was formed in the same manner of Example 2, provided that a resist pattern was formed in the pattern shape as illustrated in FIG. 53. In FIG. 53, the pattern shape was such that four squares were aligned in a width direction, and three squares were aligned in a length direction, in which each of the squares has a side of 300 nm, and spaces between the squares are 300 nm in the width direction W and 600 nm in the length direction H.

The size variations of the twelve squares were respectively calculated in the width direction and in the length direction, in the same manner of Example 1, and the average amounts were calculated. The size variations of the pattern were 60 nm in the width direction and 55 nm in the length direction. Accordingly, it was found that the resist composition of Example 2 was uniformly thickened without being affected by the spacing variations of the resist pattern.

### (Comparative Example 3)

A resist pattern was formed in the pattern shape as illustrated in FIG. 51, thickened by the resist pattern thickening material, and the average size variations of the pattern were calculated in the same manner of Example 3, provided that the resist composition was replaced with the resist composition of Comparative Example 2. The variations of the pattern size were 51 nm in the width direction and 25 nm in the length direction. Accordingly, it was found that the resist composition of Comparative Example 2 significantly varies the thickening amounts depending on the spacing variations of the pattern, and especially the thickening amount in the narrow spacing direction was large.

### (Example 4)

### -Preparation of Resist Composition-

A resist composition was prepared from 5 g of ArF resist (AR1244J, available from JSR Corporation), and 3 mg of dimethylammonium trifluoromethanesulfonate. Note that, the content of the aforementioned ammonium salt was 0.2-0.4% by mass with respect to the mass of the solid content of the ArF resist.

### -Forming of Resist Pattern-

The thus obtained resist composition was spin coated onto the entire surface of silicon wafer (available from Mitsubishi Materials Corporation) at 3,500 rpm for 20 seconds, and a prebaking was performed on the coated resist film at 110°C for 60 seconds. ArF eximer laser light was exposed thereon through a mask at a dose of 40 mJ/cm², a baking was performed on the exposed resist film at 110°C for 60 seconds, and then the baked resist film was developed with 2.38% by mass of TMAH aqueous solution for 1 minute to thereby form a resist pattern of single rectangle having a size of 120 nm x 500 nm. Note that, the thickness of the thus obtained resist pattern was 250 nm.

### -Preparation of Resist Pattern Thickening Material-

A resist pattern thickening material was prepared from 16 parts by mass of polyvinyl acetal (KW-3, available from Sekisui Chemical Co., Ltd.), 1 part by mass of 2-hydroxybenzyl alcohol, 95.5 parts by mass of pure water, 0.5 parts by mass of isopropyl alcohol, and 0.08 parts by mass of a non-ionic surfactant (PC-6 (multinucleate phenolethoxylate surfactant), available from Asahi Denka Co., Ltd.).

On the thus obtained resist pattern, the above-prepared resist pattern thickening material was spin coated at 3,500 rpm for 20 seconds. A baking was performed thereto at 110°C for 60 seconds, and the resist pattern thickening material was rinsed with pure water for 60 seconds so as to remove non-reacted portions where no interaction was occurred, to thereby develop the resist pattern thickened by the resist pattern thickening material. Thus, thickened resist pattern was formed. The variations of the pattern size were calculated and were 36 nm in the narrow side direction and 40 nm in the wide side direction.

### (Example 5)

A thickened resist pattern was formed in the same manner of Example 4, provided that a resist pattern thickening material was prepared from 16 parts by mass of polyvinyl acetal (KW-3, available from Sekisui Chemical Co., Ltd.), 1.35 part by mass of tetramethoxymethylglycoluril (a surfactant, available from Sanwa Chemical Co., Ltd.), 98.6 parts by mass of pure water, 0.4 parts by mass of isopropyl alcohol, and 0.12 parts by mass of a non-ionic surfactant (PC-6 (multinucleate phenolethoxylate surfactant), available from Asahi Denka Co., Ltd.).

The variations of the pattern size were calculated in the same manner of Example 4. The size variations of the pattern were 46 nm in the narrow side direction and 51 nm in the wide side direction. Accordingly, it was found that the resist composition was uniformly thickened without being affected by the direction of the resist pattern, even when the resist pattern thickening material comprising a surfactant was used.

### (Comparative Example 4)

A thickened resist pattern was formed and variations of the pattern size were calculated in the narrow side direction and in the wide side direction, in the same manner of Example 5, provided that dimethylammonium trifluoromethanesulfonate was not added in the process of preparing the resist composition. The variations of the pattern size were 21 nm in the narrow side direction and 46 nm in the wide side direction. Accordingly, it was found that the resist composition of Example 1 without adding triethylammonium *p*-toluenesulfonate as ammonium sulfonate significantly varies this thickening amount depending on the direction of the resist pattern, and especially the thickening amount in the wide side direction was larger than the thickening amount in the narrow direction.

### (Example 6)

A thickened resist pattern was formed and variations of the pattern size were calculated in the narrow side direction and in the wide side direction, in the same manner of Example 1, provided that triethylammonium sulfonate was replaced with monoethylammonium *p*-toluenesulfonate. The size variations of the pattern were 40 nm in the narrow side direction and 43 nm in the wide side direction. Accordingly, it was found that the resist composition comprising monoethylammonium *p*-toluenesulfonate was uniformly thickened without being affected by the direction of the resist pattern.

### (Example 7)

A thickened resist pattern was formed and variations of the pattern size were calculated in the narrow side direction and in the wide side direction, in the same manner of Example 1, provided that 1 part by mass of triethylammonium *p*-toluenesulfonate was replaced with a combination of 0.5 parts by mass of triethylammonium *p*-toluenesulfonate and 0.5 parts by mass of monoethylammonium *p*-toluenesulfonate. The size variations of the pattern were 44 nm in the narrow side direction and 47 nm in the wide side direction. Accordingly, it was found that the resist composition comprising two ammonium sulfonates was uniformly thickened without being affected by the direction of the resist pattern.

### (Example 8)

A thickened resist pattern was formed and variations of the pattern size were calculated in the narrow side direction and in the wide side direction, in the same manner of Example 1, provided that the content of triethylammonium *p*-toluenesulfonate was changed to 0.005% by mass. The size variations of the pattern were 20 nm in the narrow side direction and 35 nm in the wide side direction.

### (Example 9)

A resist composition was prepared, a resist pattern was formed by using the resist composition, and the resist pattern was thickened in the same manner of Example 1, provided that the content of triethylammonium *p*-toluenesulfonate was changed to 7% by mass. The resist composition of Example 9 was lowered in its sensitivity by approximately 30%, which affected the patterning. Accordingly, it was found that the functions as a resist would be adversely affected if more than 7% by mass of the ammonium sulfonate was added in the resist composition.

### (Example 10)

A resist composition was prepared in the same manner as Example 1, except for that triethylammonium *p*-toluenesulfonate was replaced with quaternary ammonium salts, i.e., tetramethylammonium *p*-toluenesulfonate and tetraethylammonium *p*-toluenesulfonate. However, these quaternary ammonium salts were not dissolved in the solvent of the resist material.

In addition, a resist pattern was formed by using the thus prepared resist composition, and the resist pattern was thickened. However, the results were similar to that of the resist pattern without the quaternary ammonium salts.

The size variations of the resist pattern in Examples 1-10 and Comparative Examples 1-4 are summarized in Table 1. In Table 1, "CONTENT" denoted the content of ammonium sulfonate (% by mass) with respect to a mass of the resin contained in the resist material.

**Table 1**

| | RESIST | AMMONIUM SULFONATE | | PATTERN SIZE VARIATIONS (nm) | | | |
|---|---|---|---|---|---|---|---|
| | | COMPOUND | CONTENT | NARROW SIDE | WIDE SIDE | WIDTH | LENGTH |
| Ex.1 | KrF | triethylammonium-*p*-toluenesulfonate | 1 | 52 | 55 | - | - |
| Ex.2 | KrF | methylphenylammonium-trifluoromethane sulfonate | 0.3-0.6 | 59 | 63 | - | - |
| Ex.3 | KrF | methylphenylammonium-trifluoromethane sulfonate | 0.3-0.6 | - | - | 60 | 55 |
| Ex. 4 | ArF | dimethylammonium-trifluoromethane sulfonate | 0.2-0.4 | 36 | 40 | - | - |
| Ex.5 | ArF | dimethylammonium-trifluoromethane sulfonate | 0.2-0.4 | 46 | 51 | - | - |
| Com.1 | KrF | - | - | 15 | 35 | - | - |
| Com.2 | KrF | - | - | 22 | 53 | - | - |
| Com.3 | KrF | - | - | - | - | 51 | 25 |
| Com.4 | ArF | - | - | 21 | 46 | - | - |
| Ex. 6 | KrF | monoethylammonium-*p* -toluenesulfonate | 1 | 40 | 43 | - | - |
| Ex.7 | KrF | triethylammonium-*p*-toluenesulfonate | 0.5 | 44 | 47 | - | - |
| | KrF | monoethylammonium-*p*-toluenesulfonate | 0.5 | | | | |
| Ex. 8 | KrF | triethylammonium-*p* -toluenesulfonabe | 0.005 | 20 | 35 | - | - |
| Ex.9 | KrF | triethylammonium-*p* -toluenesulfonate | 7 | - | - | - | - |
| Ex. 10 | KrF | tetramethylammonium-*p*-toluenesulfonate | 1 (not dissolved) | - | - | - | - |
| | KrF | tetraethylammonium-*p*-toluenesulfonate | 1 (not dissolved) | | | | |

As shown in Table 1, it was confirmed that the resist pattern formed of the resist composition of the present invention was uniformly and desirably thickened.

### (Example 11)

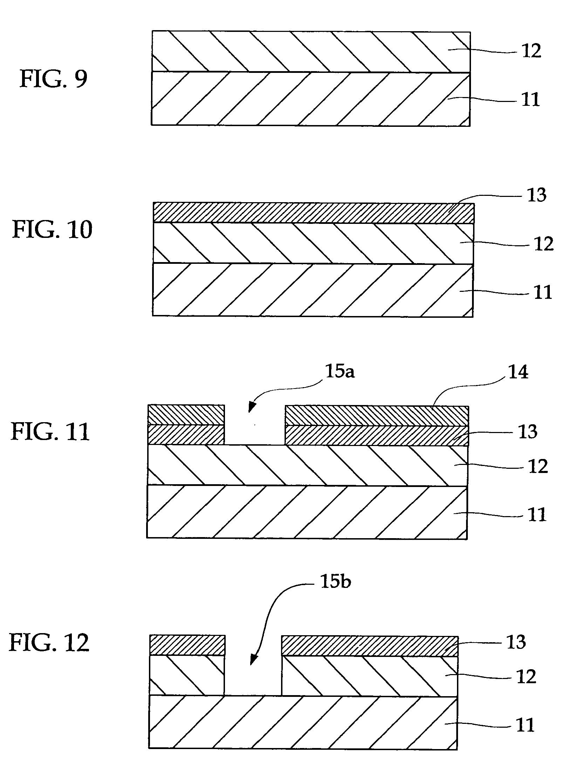

As shown in FIG. 9, an interlayer dielectric film 12 was formed on a silicon substrate 11, and as shown in FIG. 10, a titanium film 13 was formed by a sputtering method on the interlayer dielectric film 12. Next, as shown in FIG. 11, a resist pattern 14 was formed by a known photolithographic technique. By using the resist pattern 14 as a mask, the titanium film 13 was patterned by reactive ion etching to form openings 15a. Reactive ion etching was continuously carried out to remove the resist pattern 14, at the same time, as shown in FIG. 12, openings 15b were formed in the interlayer dielectric film 12 by using the titanium film 13 as a mask.

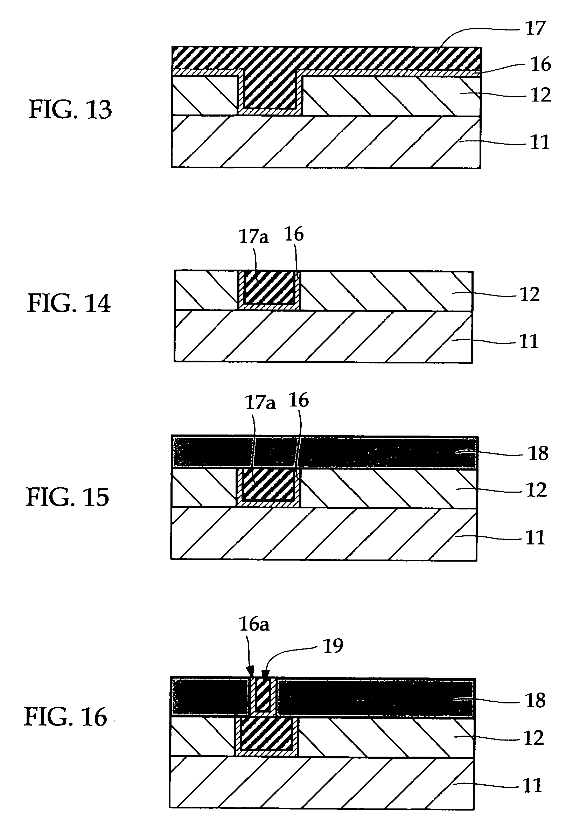

Next, the titanium film 13 was removed by wet processing, and as shown in FIG. 13, a TiN film 16 was formed on the interlayer dielectric film 12 by a sputtering method. Subsequently, a Cu film 17 was grown by an electrolytic plating method on the TiN film 16. Next, as shown in FIG. 14, planarizing was carried out by CMP such that the barrier metal and the Cu film (first metal film) remained only in the groove portions corresponding to the openings 15b (FIG. 12), and wires 17a of a first layer were formed.

Next, as shown in FIG. 15, an interlayer dielectric film 18 was formed on the wires 17a of the first layer. Thereafter, in the same way as in FIGs. 9 through 14, Cu plugs (second metal films) 19 and TiN films 16a, which connected the wires 17a of the first layer to upper layer wires which would be formed later, were formed as shown in FIG. 16.

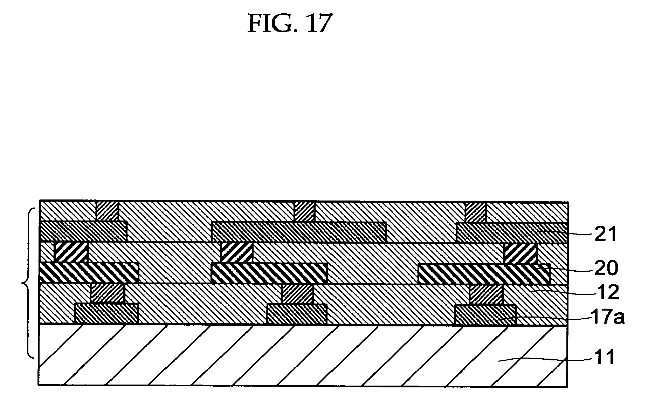

By repeating the above-described respective processes, as shown in FIG. 17, a semiconductor device was manufactured which had a multilayer wiring structure having, on the silicon substrate 11, the wires 17a of the first layer, wires 20 of a second layer, and wires 21 of a third layer. Note that the barrier metal layers formed beneath the wires of the respective layers are not shown in FIG. 17.

In Example 11, the resist pattern 14 was a thickened resist pattern which was formed from the resist composition of the present invention, and then was thickened by using the thickened resist pattern formed in the same manner of Examples 1-7.

### (Example 12)

### -Flash Memory and Manufacture Thereof-

Example 12 illustrates an embodiment of the semiconductor device and the manufacturing process thereof of the present invention using a resist pattern thickening material of the present invention. In Example 12, resist films 26, 27, 29 and 32 were thickened resist patterns which were resist patterns formed from the resist composition of the present invention, and thickened by using the thickened resist pattern formed in the same manner of Examples 1-7.

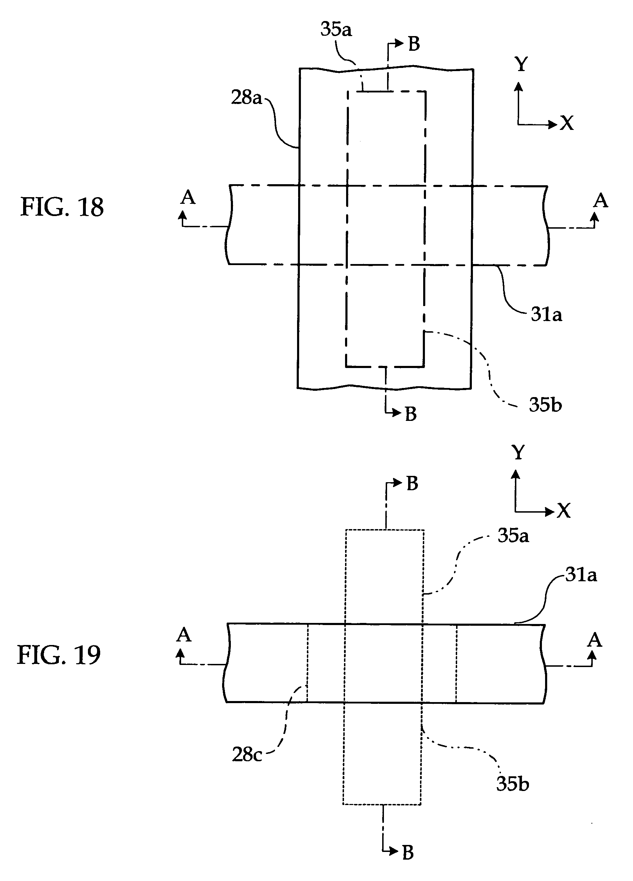

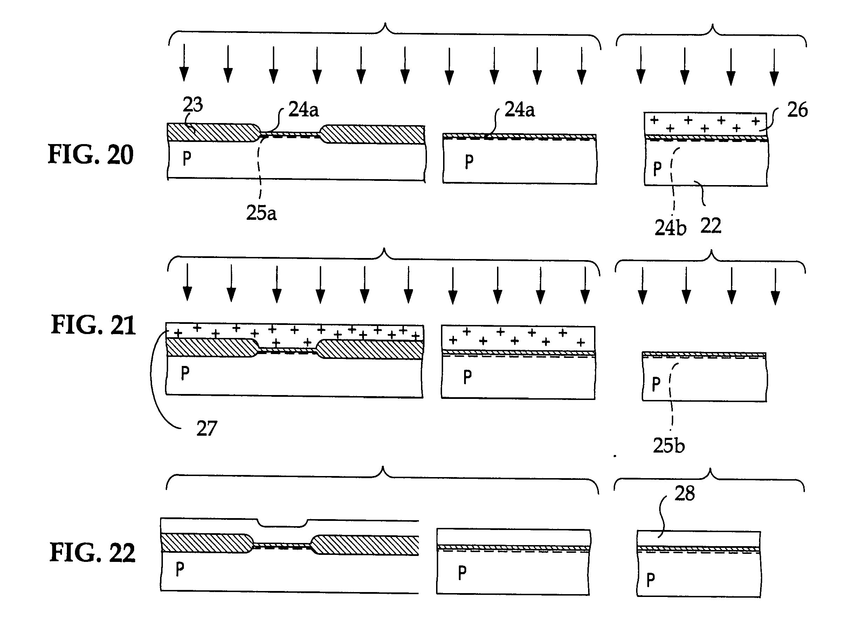

FIGs. 18 and 19 are top views (plan views) of a FLASH EPROM which is called a FLOTOX type or an ETOX type. FIGs. 20 through 28 are schematic sectional views showing a manufacturing process of the FLASH EPROM. In these figures, the left views are schematic sectional views (sectional views taken along lines A-A) of a memory cell unit (a first element region), in a gate width direction (in the X direction in FIGs. 18 and 19), in a portion where a MOS transistor having a floating gate electrode is to be formed. The central views are schematic sectional views (sectional views taken along lines B-B) of the memory cell unit in a gate length direction (in the Y direction in FIGs. 18 and 19) perpendicular to the X direction in the same portion in the left views. The right views are schematic sectional views (sectional views taken along the line A-A in FIGs. 18 and 19) of a portion on which a MOS transistor is to be formed in a peripheral circuit unit (a second element region).

Initially, a SiO₂ film was selectively formed in a device isolation region on a p-type Si substrate 22 and thereby yielded a field oxide film 23 of SiO₂ film (FIG. 20). Next, a SiO₂ film was formed by thermal oxidation to a thickness of 10 to 30 nm (100 to 300 angstroms) as a first gate dielectric film 24a in the MOS transistor in the memory cell unit (first element region). In another step, a SiO₂ film was formed by thermal oxidation to a thickness of 10 nm to 50 nm (100 angstroms to 500 angstroms) as a second gate dielectric film 24b in the MOS transistor in the peripheral circuit unit (second element region). If the first gate dielectric film 24a and the second gate dielectric film 24b should have the same thickness, these oxide films may be simultaneously formed in one step.

Next, the peripheral circuit unit (the right view in FIG. 20) was masked by a resist film 26 to control a threshold voltage for the formation of a MOS transistor having n-type depletion type channels in the memory cell unit (the left and central views in FIG. 20). As an n-type dopant, phosphorus (P) or arsenic (As) was injected into a region to be a channel region directly below the floating gate electrode by ion implantation at a dose of 1 x 10¹¹ to 1 x 10¹⁴ cm⁻² and thereby yielded a first threshold control layer 25a. The dose and conduction type of the dopant can be appropriately selected depending on whether the channel is a depletion type or an accumulation type.

Next, the memory cell unit (the left and central views in FIG. 21) was masked by a resist film 27 to control a threshold voltage for the formation of a MOS transistor having n-type depletion type channels in the peripheral circuit unit (the right view in FIG. 21). As an n-type dopant, phosphorus (P) or arsenic (As) was injected into a region to be a channel region directly below the gate electrode by ion implantation at a dose of 1 x 10¹¹ to 1 x 10¹⁴ cm⁻² and thereby yielded a second threshold control layer 25b.

A first polysilicon film (first conductive film) 28 having a thickness of 50 nm to 200 nm (500 angstroms to 2,000 angstroms) was formed on the entire surface of the article as a floating gate electrode of the MOS transistor of the memory cell unit (the left and central views in FIG. 22) and as a gate electrode of the MOS transistor in the peripheral circuit unit (the right view in FIG. 22).

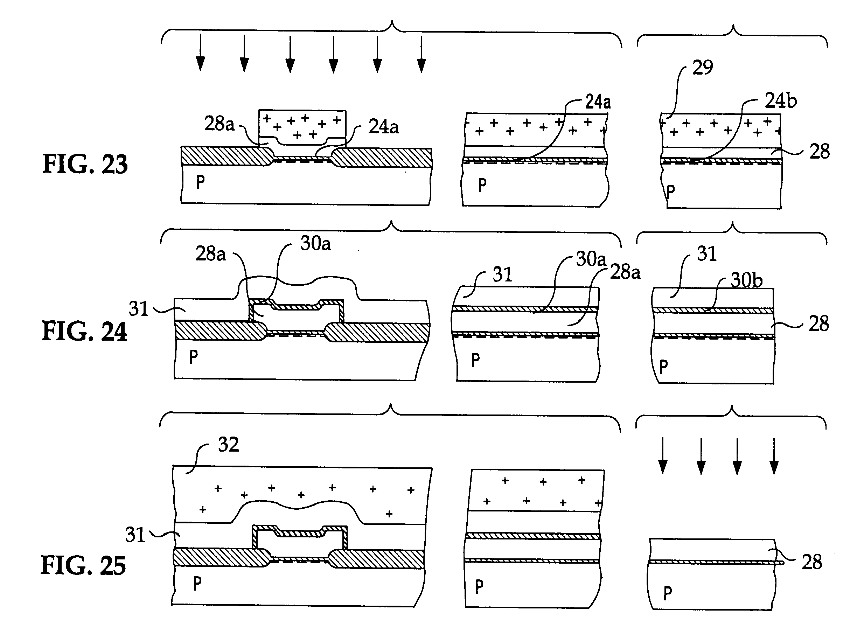

With reference to FIG. 23, a resist film 29 was then formed, the first polysilicon film 28 was patterned using the resist film 29 as a mask and thereby yielded a floating gate electrode 28a in the MOS transistor in the memory cell unit (the left and central views in FIG. 23). In this procedure, the first polysilicon film 28 was patterned in the X direction to be intended dimensions and was not patterned in the Y direction to thereby leave a region to be a source-drain (S/D) layer covered by the resist film 29.

The resist film 29 was stripped, a SiO₂ film having a thickness of about 20 nm to 50 nm (about 200 angstroms to 500 angstroms) was formed by thermal oxidation and thereby yielded a capacitor dielectric film 30a so as to cover the floating gate electrode 28a (the left and central views in FIG. 24). In this procedure, a capacitor dielectric film 30b made of a SiO₂ film was also formed on the first polysilicon film 28 in the peripheral circuit unit (the right view in FIG. 24). These capacitor dielectric films 30a and 30b are made of a SiO₂ film alone but they may comprise a multilayer film having two or three layers of SiO₂ film and Si₃N₄ film.

Next, a second polysilicon film (second conductive film) 31 was formed to a thickness of 50 nm to 200 nm (500 angstroms to 2,000 angstroms) so as to cover the floating gate electrode 28a and the capacitor dielectric film 30a (FIG. 24). The second polysilicon film 31 serves as a control gate electrode.

With reference to FIG. 25, the memory cell unit (the left and central views in FIG. 25) was masked by a resist film 32, the second polysilicon film 31 and the capacitor dielectric film 30b in the peripheral circuit unit (the right view in FIG. 25) were stripped in turn by etching to thereby expose the first polysilicon film 28 from the surface.

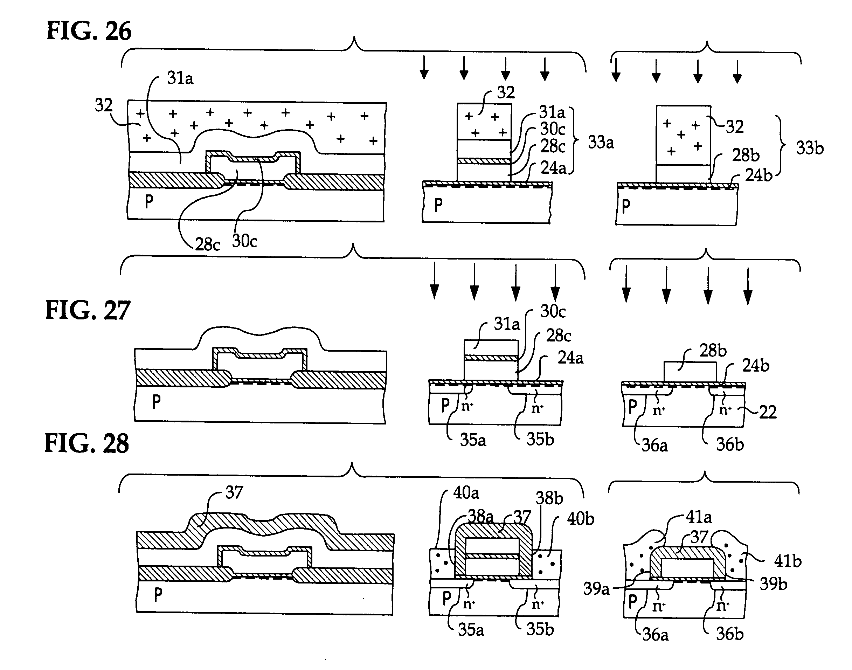

With reference to FIG. 26, the second polysilicon film 31, the capacitor dielectric film 30a, and the first polysilicon film 28a of the memory cell unit (the left and central views in FIG. 26), which first polysilicon film 28a had been patterned only in the X direction, were patterned in the Y direction to target dimensions of a first gate unit 33a using the resist film 32 as a mask. Thus, a multilayer assemblage of a control gate electrode 31a, a capacitor dielectric film 30c, and a floating gate electrode 28c having a width of about 1 µm in the Y direction was formed. In addition, the first polysilicon film 28 in the peripheral circuit unit (the right view in FIG. 26) was patterned to target dimensions of a second gate unit 33b and thereby yielded a gate electrode 28b about 1 µm wide.

Phosphorus (P) or arsenic (As) was injected into the element forming region of the Si substrate 22 by ion implantation at a dose of 1 x 10¹⁴ to 1 x 10¹⁶ cm⁻² using, as a mask, the multilayer assemblage of the control gate electrode 31a, the capacitor dielectric film 30c, and the floating gate electrode 28c in the memory cell unit (the left and central views in FIG. 27) and thereby yielded n-type source and drain (S/D) region layers 35a and 35b. In addition, phosphorus (P) or arsenic (As) as an n-type dopant was injected into the element forming region of the Si substrate 22 by ion implantation at a dose of 1 x 10¹⁴ to 1 x 10¹⁶ cm⁻² using the gate electrode 28b in the peripheral circuit unit (the right view in FIG. 27) as a mask and thereby yielded S/D region layers 36a and 36b.

A phosphate-silicate glass film (PSG film) about 500 nm (5000 angstroms) thick was formed as an interlayer dielectric film 37 so as to cover the first gate unit 33a in the memory cell unit (the left and central views in FIG. 28) and the second gate unit 33b in the peripheral circuit unit (the right view in FIG. 28).

Subsequently, contact holes 38a, 38b, 39a, and 39b were formed on the interlayer dielectric film 37 on the S/D region layers 35, 35b, 36a, and 36b, respectively. S/D electrodes 40a, 40b, 41a and 41b were then formed respectively. In order to form the contact holes 38a, 38b, 39a and 39b, the hole pattern was formed with the resist material according to the present invention, which was then thickened by the resist pattern thickening material, thereby forming fine space patterns (hole patterns). Thereafter, the contact holes were manufactured in accordance with a conventional method.

Thus, the FLASH EPROM as a semiconductor device was manufactured (FIG. 28).

In the above-manufactured FLASH EPROM, the second gate dielectric film 24b in the peripheral circuit unit (the right views in FIGs. 20 through 28) remains being covered by the first polysilicon film 28 or the gate electrode 28b after its formation (the right views in FIGs. 20 through 28) and thereby keeps its initial thickness. Accordingly, the thickness of the second gate dielectric film 24b can be easily controlled, and the concentration of a conductive dopant can be easily controlled for the control of the threshold voltage.

In this embodiment, the first gate unit 33a is formed by initially patterning in the gate width direction (the X direction in FIGs. 18 and 19) to a set width and then patterning in the gate length direction (the Y direction in FIGs. 18 and 19) to a target width. Alternatively, the first gate unit 33a may be formed by initially patterning in the gate length direction (the Y direction in FIGs. 18 and 19) to a set width and then patterning in the gate width direction (the X direction in FIGs. 18 and 19) to a target width.

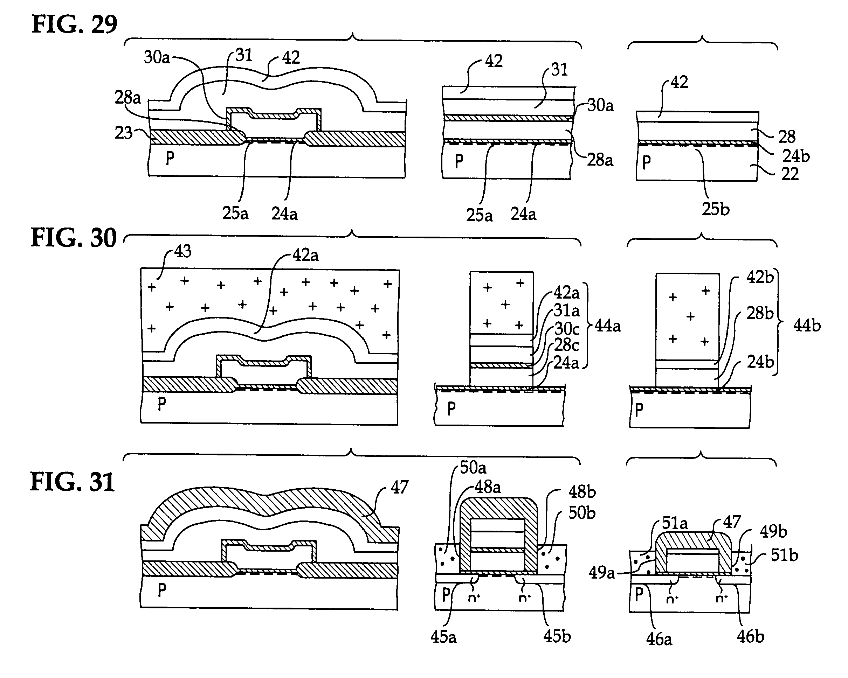

Another FLASH EPROM was manufactured in the same way as in the above embodiment, except that the steps subsequent to the step of FIG. 28 were changed to those shown in FIGs. 29, 30 and 31. This manufacture is similar to the above embodiment, except for the followings. Specifically, a tungsten (W) film or a titanium (Ti) film about 200 nm (2,000 angstroms) thick was formed as a refractory metal film (fourth conductive film) 42 on the second polysilicon film 31 in the memory cell unit (the left and central views in FIG. 29) and the first polysilicon film 28 in the peripheral circuit unit (the right view in FIG. 29) and thereby yielded a polycide film. The steps of FIGs. 30 and 31 subsequent to the step of FIG. 29 were carried out in the same manner as in FIGs. 26, 27, and 28 and a detailed description thereof is omitted. The same components in FIGs. 29, 30, and 31 as in FIGs. 26, 27, and 28 have the same reference numerals.

Thus, a FLASH EPROM as a semiconductor device was manufactured (FIG. 31).

The above-manufactured FLASH EPROM has the refracrory metal films (fourth conductive films) 42a and 42b on the control gate electrode 31a and the gate electrode 28b and can thereby further reduce its electrical resistance.

In this embodiment, the refracrory metal films 42a and 42b are used as the fourth conductive films. Alternatively, refractory metal silicide films such as titanium silicide (TiSi) films can be used.

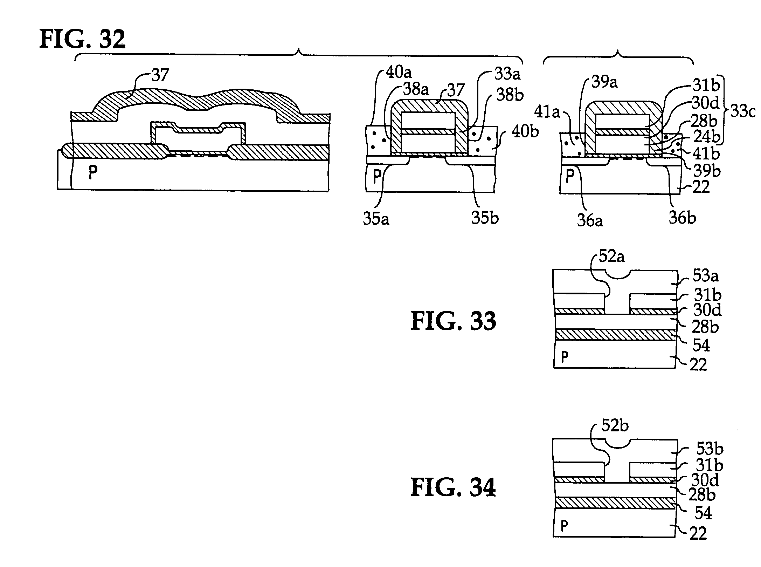

Yet another FLASH EPROM was manufactured by the manufacture procedure as in the aforementioned embodiment, except for steps shown in FIGs. 32, 33, and 34. Specifically, a second gate unit 33c in the peripheral circuit unit (second element region) (the right view in FIG. 32) has a multilayer structure comprising a first polysilicon film (first conductive film) 28b, a SiO₂ film (capacitor dielectric film) 30d, and a second polysilicon film (second conductive film) 31b arranged in this order as in the first gate unit 33a in the memory cell unit (the left and central views in FIG. 32). The first polysilicon film 28b and the second polysilicon film 31b are bridged and thereby form a gate electrode (FIGs. 33 and 34).

More specifically, with reference to FIG. 33, the first polysilicon film 28b and the second polysilicon film 31b are bridged by forming an opening 52a penetrating the first polysilicon film (first conductive film) 28b, the SiO₂ film (capacitor dielectric film) 30d and the second polysilicon film (second conductive film) 31b at another portion than the second gate unit 33c shown in FIG. 32, for example, on the dielectric film 54, and filling the opening 52a with a refractory metal film (third conductive film) 53a such as a W film or a Ti film. Alternatively, with reference to FIG. 34, the first polysilicon film 28b and the second polysilicon film 31b may be bridged by forming an opening 52b penetrating the first polysilicon film (first conductive film) 28b and the SiO₂ film (capacitor dielectric film) 30d, thereby exposing the lower first polysilicon film 28b at the bottom of the opening 52b, and filling the opening 52b with a refractory metal film 53b such as a W film or a Ti film.

In the above-manufactured FLASH EPROM, the second gate unit 33c in the peripheral circuit unit has the same structure as the first gate unit 33a in the memory cell unit. Accordingly, the memory cell unit and the peripheral circuit unit can be formed by the same step to thereby efficiently simplify steps of the manufacture process.

In this embodiment, the third conductive film 53a or 53b and the refractory metal film (fourth conductive film) 42 were formed independently. Alternatively, these films may be formed simultaneously as a refractory metal film in common.

### (Example 13)

### -Manufacture of Magnetic Head-

Example 13 relates to the manufacture of a magnetic head as an application embodiment of the resist pattern formed from the resist composition of the present invention. In Example 13, after-mentioned resist patterns 102 and 126 were formed from the resist composition of the present invention, and thickened resist patterns formed by using the resist pattern thickening material in the same manner of Examples 1-7.

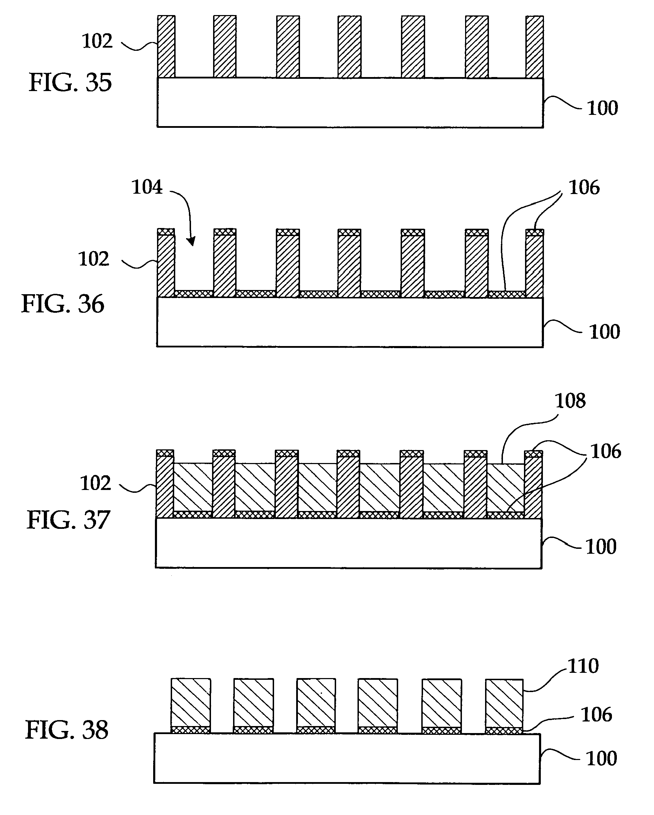

FIGs. 35 through 38 show steps for the manufacture of the magnetic head.

Initially, a resist film was formed to a thickness of 6 µm on an interlayer dielectric layer 100, was exposed to light, was developed and thereby yielded a resist pattern 102 having an opening pattern for the formation of a spiral thin film magnetic coil (FIG. 35).

Next, a plated underlayer 106 comprising a multilayer structure comprising a Ti contact film 0.01 µm thick and a Cu contact film 0.05 µm thick was formed by vapor deposition on the resist pattern 102 and on the exposed surface of the interlayer dielectric layer 100 at the bottom of the opening 104 in a portion where the resist pattern 102 was not formed (FIG. 36).

A Cu-plated film 3 µm thick as a thin-film conductor 108 was formed on the surface of the plated underlayer 106 above the exposed surface of the interlayer dielectric layer 100 at the bottom of the opening 104 in a portion where the resist pattern 102 was not formed (FIG. 37).

The resist pattern 102 was dissolved, was removed by lift-off from the interlayer dielectric layer 100 and thereby yielded a spiral thin-film magnetic coil 110 derived from the spiral pattern of the thin-film conductor 108 (FIG. 38).

Thus, the magnetic head was manufactured.

The above-manufactured magnetic head has the thin film magnetic coil 110 with fine and precise dimensions, since the fine spiral pattern was formed by using the resist pattern 102 thickened using the resist pattern thickening material of the present invention. In addition, the magnetic head can be satisfactorily manufactured in mass production.

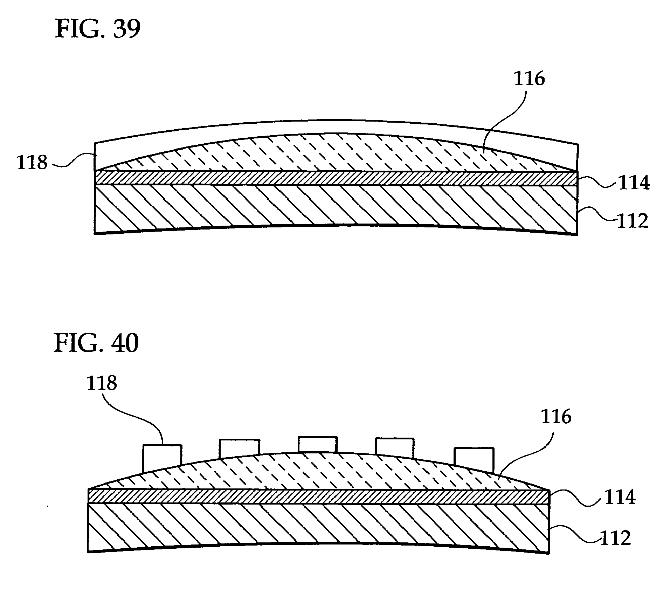

Another magnetic head was manufactured by steps shown in FIGs. 39 through 44.

A gap layer 114 was formed by sputtering so as to cover a ceramic non-magnetic substrate 112 (FIG. 39). The non-magnetic substrate 112 had an insulating layer of silicon oxide, a conductive underlayer of a Ni-Fe permalloy formed by sputtering, and a lower magnetic layer of a Ni-Fe permalloy formed in advance on its surface. These layers are not shown in the figures. A resin dielectric film 116 was formed from a thermosetting resin in a set region on the gap layer 114 except a region to be a magnetic tip (magnetic head) of the lower magnetic layer (not shown). A resist composition was then applied to the resin dielectric film 116 and thereby yielded a resist film 118.

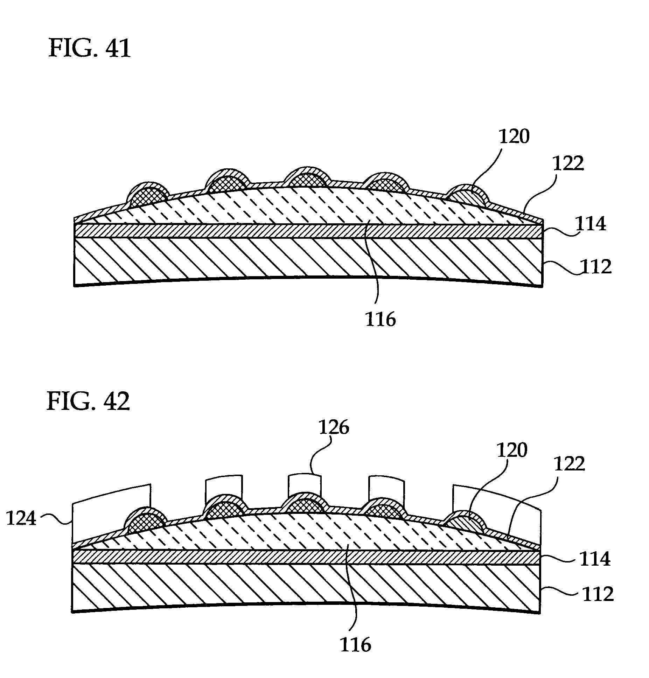

The resist film 118 was exposed to light, was developed and thereby yielded a spiral pattern (FIG. 40). The spirally patterned resist film 118 was subjected to thermal curing at several hundred Celsius degrees for about one hour and thereby yielded a protruded first spiral pattern 120 (FIG. 41). A conductive workpiece surface 122 of Cu was formed so as to cover the surface of the first spiral pattern 120.

A resist material in accordance with the present invention was applied to the conductive workpiece surface 122 by spin coating and thereby yielded a resist film 124 thereon. Subsequently, the resist film 124 was patterned corresponding to the first spiral pattern 120 and thereby yielded a resist pattern 126 (FIG. 42).

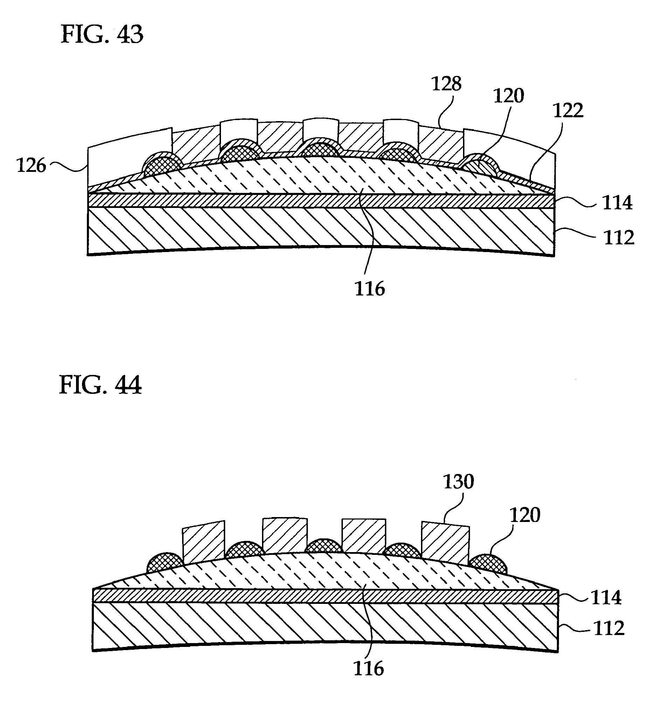

A Cu conductive layer 128 was formed by plating on the exposed surface of the conductive workpiece surface 122 in a portion where the resist pattern 126 was not formed (FIG. 43). The resist pattern 126 was lifted off from the conductive workpiece surface 122 by dissolving and thereby yielded a spiral thin-film magnetic coil 130 derived from the Cu conductive layer 128 (FIG. 44).

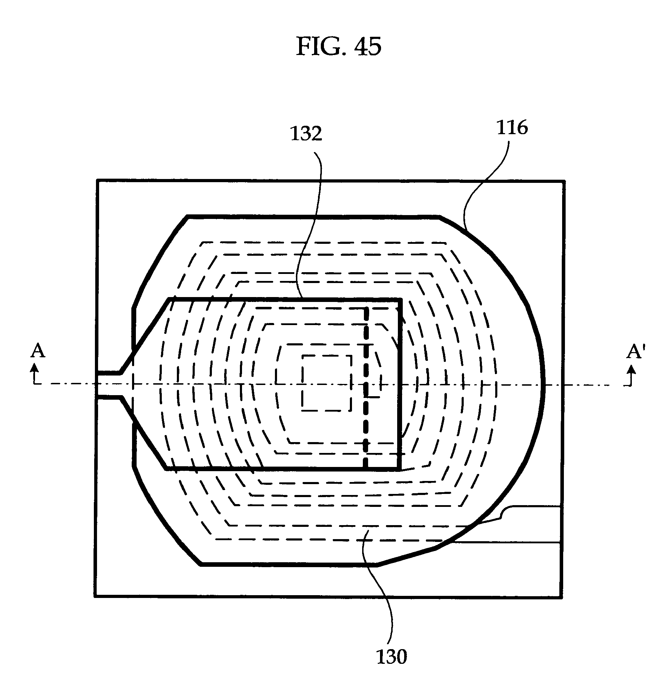

Thus, the magnetic head as shown in a plan view of FIG. 45 was manufactured. The magnetic head has a magnetic layer 132 on the resin dielectric film 116 with the thin-film magnetic coil 130 on its surface.

The above-manufactured magnetic head has the thin-film magnetic coil 130 with fine and precise dimensions, since the fine spiral pattern was formed by using the resist pattern 126 thickened by the resist pattern thickening material of the present invention. In addition, the magnetic head can be satisfactorily manufactured in mass production.

The present invention can solve the conventional problems and achieve the aforementioned objects.

The present invention provides a resist composition, which can utilize ArF excimer laser light as exposure light during patterning; and which forms, as a result of exposure and developing, such a resist pattern that is suitable for thickening by being applied a resist pattern thickening material over the surface thereof, is uniformly thickened without being affected by the direction and/or spacing variations of the resist pattern, components of the resist pattern thickening material and the like, and is able to form a fine space pattern exceeding exposure or resolution limits of a light source of an exposure device with efficiency and simple procedure at low cost.

The present invention provides a method for forming a resist pattern which, during patterning a resist pattern, can utilize ArF excimer laser light as a light source; which can uniformly thicken a resist pattern without being affected by the direction and/or spacing variations of the resist pattern, components of the resist pattern thickening material and the like; and which is suitable for forming a fine space pattern exceeding exposure or resolution limits of a light source of an exposure device with efficiency and simple procedure at low cost.

The present invention provides a method for manufacturing a semiconductor device which, during patterning a resist pattern, can utilize ArF excimer laser light as a light source; which can uniformly thicken a resist pattern without being affected by the direction and/or spacing variations of the resist pattern, components of the resist pattern thickening material and the like; which is suitable for forming a fine space pattern exceeding exposure or resolution limits of a light source of an exposure device with efficiency and simple procedure at low cost.; and which is able to efficiently mass-produce high-performance semiconductors each having a fine wiring pattern formed by using the fine space pattern, as well as providing a high-performance semiconductor which is manufactured by the method for manufacturing a semiconductor device and which has fine wiring patterns.

The resist composition of the present invention is suitable for forming a resist pattern over which a resist pattern thickening material is applied to thereby thicken the resist pattern, the resist pattern formed from the resist composition of the present invention is uniformly thickened without being affected by the direction and/or spacing variations of the resist pattern, components of the resist pattern thickening material and the like, and thus a fine space pattern is formed exceeding the exposure or resolution limits of a light source of an exposure device. Therefore, the resist composition of the present invention is also suitably applicable for various patterning methods and methods for manufacturing a semiconductor, and is particularly suitably applicable for the method for forming a resist pattern of the present invention and the method for manufacturing a semiconductor device of the present invention.

The method for forming a resist pattern of the present invention is suitably applicable for manufacturing functional parts such as mask patterns, reticule patterns, magnetic heads, LCDs (liquid crystal displays), PDPs (plasma display panels), SAW filters (surface acoustic wave filters); optical parts used in connecting optical wiring; fine parts such as microactuators; semiconductor devices; and the like, and can be suitably employed in the method for manufacturing a semiconductor device of the present invention.

The method for manufacturing a semiconductor device of the present invention is suitably applicable for a manufacturing procedure of various semiconductor devices, such as flash memory, DRAM, FRAM and the like.

The present invention is described based on the embodiments which the inventors of the present invention thought as the best mode. However, the present invention is not intended to be limited to the specific embodiments described in this specification, and one skilled in the art can modify the embodiments within the scope of the invention.

## Claims

1. A composition comprising, a resist material and an ammonium sulfonate.

2. The composition according to Claim 1, wherein the ammonium sulfonate comprises a sulfonium moiety and an ammonium moiety, the sulfonium moiety being at least one selected from a trifluoromethane sulfonium anion and a toluene sulfonium anion.

3. The composition according to Claim 1 or 2, wherein the ammonium sulfonate comprises a sulfonium moiety and an ammonium moiety, the ammonium moiety being at least one selected from a primary ammonium cation, a secondary ammonium cation, and a tertiary ammonium cation.

4. The composition according to any one of Claims 1 to 3, wherein the ammonium sulfonate comprises a sulfonium moiety and an ammonium moiety, the ammonium moiety being an ion expressed by Formula 1:
N⁺R¹R²R³R⁴ Formula 1
provided that, N is a nitrogen atom, at least one of R¹ to R⁴ is a hydrogen atom, and the others are selected from the group consisting of a C₁₋₄ alkyl group and a phenyl group.

5. The composition according to any one of Claims 1 to 4, wherein a content of the ammonium sulfonate is 0.01 % by mass to 5 % by mass with respect to the total solids mass of the resist composition.

6. The composition according to any one of Claims 1 to 5, wherein the resist composition is at least one selected from the group consisting of an acrylic resist comprising an acrylic resin having an alicyclic functional group at a side chain thereof, a cycloolefin-maleic acid anhydride resist, and a cycloolefin resist.

7. The composition according to Claim 6, wherein the alicyclic functional group is selected from the group consisting of an adamanthyl functional group and a norbornane group, and
the cycloolefin resist comprises cycloolefin comprising, in a principal chain thereof, at least one selected from the group consisting of norbornane and adamantane.

8. The composition according to any one of Claims 1 to 7, wherein the composition has a sensitivity to an exposure light having a wavelength of 440 nm or shorter.

9. The composition according to Claim 8, wherein the exposure light is at least one selected from the group consisting of a g-ray, an i-ray, a KrF eximer laser light, an ArF eximer laser light, an F₂ eximer laser light, and an electron beam.

10. A method, comprising:
forming a resist pattern from the composition according to any one of Claims 1 to 9; and
applying a resist pattern thickening material over the resist pattern so as to cover a surface of the resist pattern.

11. The method according to Claim 10, further comprising:
developing the resist pattern thickening material after the applying.

12. The method according to Claim 11, wherein the developing is performed with water.

13. A method for manufacturing a semiconductor device, comprising:
forming, on a surface of a workpiece, a resist pattern from the composition according to any one of Claims 1 to 9;
applying a resist pattern thickening material over the resist pattern so as to cover a surface of the resist pattern to thereby thicken the resist pattern; and
etching the surface of the workpiece using the thickened resist pattern as a mask so as to pattern the surface of the workpiece.

14. The method according to Claim 13, further comprising:
coating a non-ionic surfactant to the surface of the resist pattern, prior to the applying a resist pattern thickening material,
wherein the non-ionic surfactant is at least one selected from the group consisting of a polyoxyethylene-polyoxypropylene condensation product, polyoxyalkylene alkylether, polyoxyethylene alkylether, a polyoxyethylene derivative, sorbitan fatty acid ester, glycerin fatty acid ester, primary alcohol ethoxylate, and phenol ethoxylate.

15. A semiconductor device manufactured by the process according to Claim 13 or 14.
